# EUROPEAN PATENT APPLICATION

(11) **EP 4 657 512 A1**
(43) Date of publication of application: **03.12.2025**
(21) Application number: 25154935.8
(22) Date of filing: 30.01.2025
(51) Int. Cl.: H01L 21/67

(54) **SUBSTRATE TREATING APPARATUS AND SEMICONDUCTOR MANUFACTURING EQUIPMENT INCLUDING THE SAME**

(30) Priority: 28.05.2024 KR 20240069024
(71) Applicant: Samsung Electronics Co., Ltd., Suwon-si, Gyeonggi-do 16677 (KR)
(72) Inventor: JUNG, Ji Woong, 16677 Suwon-si, Gyeonggi-do (KR); NOH, Sung Jun, 16677 Suwon-si, Gyeonggi-do (KR); LEE, Jun Ho, 16677 Suwon-si, Gyeonggi-do (KR); JEONG, Ji Hoon, 16677 Suwon-si, Gyeonggi-do (KR); KIM, Tae Heon, 16677 Suwon-si, Gyeonggi-do (KR); YOON, Jun Ho, 16677 Suwon-si, Gyeonggi-do (KR); LEE, Jong Won, 16677 Suwon-si, Gyeonggi-do (KR)
(74) Representative: Kuhnen & Wacker Patent- und Rechtsanwaltsbüro PartG mbB

(57) **Abstract**

A substrate treating apparatus to minimize the occurrence of turbulent flow in the edge direction of the substrate and semiconductor manufacturing equipment including the substrate treating apparatus are provided. The substrate treating apparatus includes an upper module including a first supply port providing supercritical fluid to a substrate treating space, a lower module coupled to the upper module and including a second supply port providing the supercritical fluid to the substrate treating space, a shielding plate disposed in the substrate treating space, a plate support coupled to the lower module and supporting the shielding plate, and a first substrate support coupled to the shielding plate and supporting the substrate. A fluid flow path between the lower module and the shielding plate includes a throat structure changing a cross-sectional size of the fluid flow path.

## Description

### CROSS-REFERENCE TO RELATED APPLICATION

This application claims priority under 35 U.S.C. §119 to Korean Patent Application No. 10-2024-0069024, filed on May 28, 2024 in the Korean Intellectual Property Office, the contents of which are herein incorporated by reference in their entirety.

### TECHNICAL FIELD

The present disclosure relates to a substrate treating apparatus that performs a drying process and semiconductor manufacturing equipment including the same.

### DISCUSSION OF THE RELATED ART

In manufacturing a semiconductor device, a chemical cleaning process may be followed by a drying process that uses a supercritical fluid. However, when the supercritical fluid reaches a top of the substrate, turbulent flow may occur near an edge of the substrate, causing the pattern to experience shear stress. As a result of the shear stress, pattern collapse may occur in the edge area of the substrate.

### SUMMARY

A substrate treating apparatus includes an upper module including a first supply port providing supercritical fluid to a substrate treating space. A lower module is coupled to the upper module and includes a second supply port providing the supercritical fluid to the substrate treating space. A shielding plate is disposed in the substrate treating space. A plate support is coupled to the lower module and supports the shielding plate. A first substrate support is coupled to the shielding plate and supports the substrate. A fluid flow path between the lower module and the shielding plate includes a throat structure changing a cross-sectional size of the fluid flow path.

A semiconductor manufacturing equipment includes a cleaning process chamber configured to wet-clean a substrate using a chemical. A drying process chamber is configured to dry the substrate having the chemical remaining thereon using supercritical fluid. The drying process chamber includes an upper module including a first supply port providing the supercritical fluid to a substrate treating space, a lower module coupled to the upper module and including a second supply port providing the supercritical fluid to the substrate treating space, a shielding plate disposed in the substrate treating space, a plate support coupled to the lower module and supporting the shielding plate, and a first substrate support coupled to the shielding plate and supporting the substrate. A fluid flow path between the lower module and the shielding plate includes a throat structure changing a cross-sectional size of the fluid flow path.

A substrate treating apparatus includes an upper module including a first supply port providing supercritical fluid to a substrate treating space. A lower module is coupled to the upper module and includes a second supply port providing the supercritical fluid to the substrate treating space. A shielding plate is disposed in the substrate treating space. A plate support is coupled to the lower module and supports the shielding plate. A first substrate support is coupled to the shielding plate and supports the substrate. A fluid flow path between the lower module and the shielding plate includes a throat structure changing a cross-sectional size of the fluid flow path. The throat structure includes a first protrusion. The first protrusion is formed in the shielding plate and/or the lower module. The shielding plate includes a filler body, a filler volume increasing plate stacked on the filler body, and a filler cap stacked on the filler volume increasing plate. Each of the filler volume increasing plate and the filler cap is movable horizontally. Each of the filler volume increasing plate and the filler cap are divided into a plurality of portions in a plan view. Directions in which the plurality of portions of the filler volume increasing plate move are different from directions in which the plurality of portions of the filler cap move, respectively. The first substrate support and/or the plate support is movable vertically.

### BRIEF DESCRIPTION OF DRAWINGS

The above and other aspects and features of the present disclosure will become more apparent by describing in detail embodiments thereof with reference to the attached drawings, in which:
FIG. 1 is a schematic diagram illustrating semiconductor manufacturing equipment according to embodiments of the present disclosure.
FIG. 2 is a schematic diagram illustrating semiconductor manufacturing equipment according to embodiments of the present disclosure.
FIG. 3 is a schematic diagram illustrating a process chamber according to embodiments of the present disclosure.
FIG. 4 is a schematic diagram illustrating a process chamber according to embodiments of the present disclosure.
FIG. 5 and FIG. 6 are schematic diagrams illustrating a process chamber according to embodiments of the present disclosure.
FIG. 7 is a schematic diagram illustrating an effect of the throat structure according to embodiments of the present disclosure.
FIG. 8 is a schematic diagram illustrating the throat structure according to embodiments of the present disclosure.
FIG. 9 is a schematic diagram illustrating the throat structure according to embodiments of the present disclosure.
FIG. 10 is a schematic diagram illustrating the throat structure according to embodiments of the present disclosure.
FIG. 11 is a schematic diagram illustrating the throat structure according to embodiments of the present disclosure.
FIG. 12 is a schematic diagram illustrating the throat structure according to embodiments of the present disclosure.
FIG. 13 is a schematic diagram illustrating the throat structure according to embodiments of the present disclosure.
FIG. 14 is a schematic diagram illustrating the throat structure according to embodiments of the present disclosure.
FIG. 15 is a schematic diagram illustrating the throat structure according to embodiments of the present disclosure.
FIG. 16 is a schematic diagram illustrating a structure of a shielding plate according to embodiments of the present disclosure.
FIG. 17 is a schematic diagram illustrating the structure of the shielding plate according to embodiments of the present disclosure.
FIG. 18 is a schematic diagram illustrating the structure of the shielding plate according to embodiments of the present disclosure.
FIG. 19 is a schematic diagram illustrating the structure of the shielding plate according to embodiments of the present disclosure.
FIG. 20 is a schematic diagram illustrating the structure of the shielding plate according to embodiments of the present disclosure.
FIG. 21 is a schematic diagram illustrating the structure of the shielding plate according to embodiments of the present disclosure.
FIG. 22 is a schematic diagram illustrating the structure of the shielding plate according to embodiments of the present disclosure.
FIG. 23 is a schematic diagram illustrating the structure of the shielding plate according to embodiments of the present disclosure.
FIG. 24 is a schematic diagram illustrating the structure of the shielding plate according to embodiments of the present disclosure.
FIG. 25 is a schematic diagram illustrating the structure of the shielding plate according to embodiments of the present disclosure.
FIG. 26 is a schematic diagram illustrating the structure of the shielding plate according to embodiments of the present disclosure.
FIG. 27 is a schematic diagram illustrating the structure of the shielding plate according to embodiments of the present disclosure.
FIG. 28 is a schematic diagram illustrating the structure of the shielding plate according to embodiments of the present disclosure.
FIG. 29 is a schematic diagram illustrating the structure of the shielding plate according to embodiments of the present disclosure.
FIG. 30 is a schematic diagram illustrating the structure of the shielding plate according to embodiments of the present disclosure.
FIG. 31 is a schematic diagram illustrating the structure of the shielding plate according to embodiments of the present disclosure.
FIG. 32 is a schematic diagram illustrating the structure of the shielding plate according to embodiments of the present disclosure.
FIG. 33 is a schematic diagram illustrating the structure of the shielding plate according to embodiments of the present disclosure.
FIG. 34 is a schematic diagram illustrating the second substrate support according to embodiments of the present disclosure.
FIG. 35 is a schematic diagram illustrating the plate support according to embodiments of the present disclosure.
FIG. 36 is a flowchart illustrating a supercritical drying process according to embodiments of the present disclosure.

### DETAILED DESCRIPTIONS

Embodiments of the present disclosure will hereinafter be described with reference to the accompanying drawings. The same reference numerals may be used to refer to identical components in the specification and the drawings, and to the extent that an element is not described in detail with respect to a given figure, it may be understood that the element is at least similar to a corresponding element that has been described elsewhere within the present disclosure.

As a semiconductor pattern becomes miniaturized, an aspect ratio of the pattern increases, and as a result, it may be more difficult to prevent the phenomenon of pattern collapse. Thus, the present disclosure provides a substrate treating apparatus that prevents pattern collapse in an edge area of the substrate and semiconductor manufacturing equipment including the same.

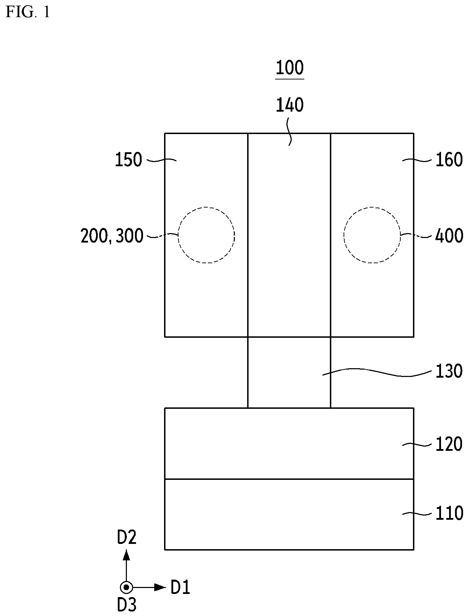

FIG. 1 is a schematic diagram illustrating semiconductor manufacturing equipment according to embodiments of the present disclosure. Referring to FIG. 1, semiconductor manufacturing equipment 100 may be configured to include a load port module 110, an index module 120, a buffer module 130, a transfer module 140, a first portion 150, and a second portion 160.

A first direction D 1 and a second direction D2 may constitute a two-dimensional plane. The first direction D1 may be an X-axis direction, and the second direction D2 may be a Y-axis direction. The first direction D1 may be a left-right direction, and the second direction D2 may be a front-back direction. Alternatively, the first direction D1 may be a front-to-back direction, and the second direction D2 may be a left-right direction. A third direction D3 together with the first direction D1 and the second direction D2 may constitute a three-dimensional structure. The third direction D3 is a direction perpendicular to the plane defined by the first direction D1 and the second direction D2. The third direction D3 may be the Z-axis direction. The third direction D3 may be a vertical direction.

The semiconductor manufacturing equipment 100 may be equipment that performs a photo process on a substrate. The semiconductor manufacturing equipment 100 may include a chamber that performs a cleaning process and a chamber that performs a drying process. However, embodiments of the present disclosure are not necessarily limited thereto, and the semiconductor manufacturing equipment 100 may include only a chamber that performs a drying process. The semiconductor manufacturing equipment 100 may further include a chamber for performing an etching process in addition to the above two chambers. Alternatively, the semiconductor manufacturing equipment 100 may further include a chamber that performs a thermal treating process. Hereinafter, an example will be described where the semiconductor manufacturing equipment 100 includes a chamber for performing a cleaning process and a chamber for performing a drying process.

The load port module 110 is configured so that a container may be seated therein. The container may accommodate therein a plurality of substrates. For example, the substrate may be a wafer and the container may be a Front Opening Unified Pod (FOUP). The container may be loaded or unloaded into or from the load port module 110. The substrate stored in the container may be loaded or unloaded into or from the load port module 110.

A plurality of containers may be seated in the load port module 110. The plurality of containers may contain therein objects of the same type. For example, each of a first container, a second container, and a third container may load a wafer. However, embodiments of the present disclosure are not necessarily limited thereto, and the containers may contain therein different types of objects. For example, the first container may contain a wafer, the second container may contain a wafer-type sensor, and the third container may contain a consumable part such as a focus ring.

The index module 120 may be disposed behind the load port module 110. The index module 120 may be provided as an interface so that the substrate may be transferred between the load port module 110 and the buffer module 130.

The index module 120 may include a first transfer robot for loading and unloading the substrate. The first transfer robot may load and unload the substrate in an atmospheric pressure environment. The load port module 110 and the index module 120 may constitute an equipment front end module (EFEM).

The buffer module 130 may temporarily store therein the substrate. The buffer module 130 may store therein an untreated substrate before returning the same to the first portion 150. The buffer module 130 may store therein a treated substrate before returning the same to the load port module 110.

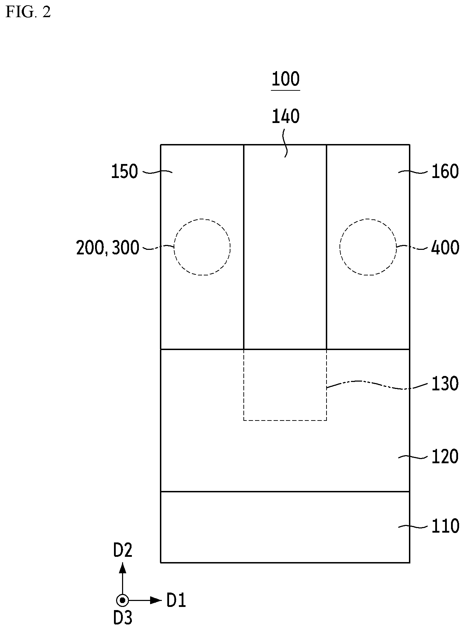

The buffer module 130 may be disposed behind the index module 120. The buffer module 130 may be disposed between the index module 120 and the transfer module 140. However, an embodiment is not necessarily limited thereto. Referring to FIG. 2, the buffer module 130 may be disposed inside the index module 120. The buffer module 130 may be adjacent to the transfer module 140 while being disposed within the index module 120. FIG. 2 is a schematic diagram illustrating semiconductor manufacturing equipment according to embodiments of the present disclosure.

Hereinafter, descriptions will be made with reference to FIG. 1 and FIG. 2.

The transfer module 140 may be provided as an interface for transferring the substrate between the first portion 150 and the second portion 160. The transfer module 140 may be provided as an interface for transferring the substrate between the buffer module 130 and the first portion 150. The transfer module 140 may be provided as an interface for transferring the substrate between the buffer module 130 and the second portion 160. The transfer module 140 may be surrounded by the index module 120, the first portion 150, and the second portion 160.

The transfer module 140 may include a second transfer robot for loading and unloading the substrate. The first transfer robot and the second transfer robot may import and export the substrate in the same environment. The second transfer robot may import and export the substrate in an atmospheric pressure environment.

The first portion 150 may perform a cleaning process on the substrate. The first portion 150 may include a first process chamber 200. Alternatively, the first portion 150 may include a second process chamber 300. The first process chamber 200 and the second process chamber 300 may clean the substrate using a chemical. The first process chamber 200 and the second process chamber 300 may clean the substrate in a wet manner. Each of the first process chamber 200 and the second process chamber 300 may be provided in a plural manner. A more detailed description of the first process chamber 200 and the second process chamber 300 will be set forth later.

The second portion 160 may perform a drying process on the substrate. The second portion 160 may include a third process chamber 400. The third process chamber 400 may dry the substrate using the supercritical fluid. For example, the supercritical fluid may be carbon dioxide (CO₂). A plurality of third process chambers 400 to be provided. A more detailed description of the third process chamber 400 will be set forth later.

The first portion 150 and the second portion 160 may be disposed on both opposing sides of the transfer module 140, respectively. In this case, the first process chamber 200 or the second process chamber 300 may be provided on one side of the transfer module 140, and the third process chamber 400 may be provided on the other side of the transfer module 140. However, embodiments of the present disclosure are not necessarily limited thereto, and one of the first process chamber 200 and the second process chamber 300, and the third process chamber 400 may be provided together on each of both opposing sides of the transfer module 140. Alternatively, one of the first process chamber 200 and the second process chamber 300 and the third process chamber 400 may be provided together on only one side of the transfer module 140.

The semiconductor manufacturing equipment 100 may include a control device. The control device may include a processor that controls each of components constituting the semiconductor manufacturing equipment 100, a network that communicates, in a wired or wireless manner, with each of the components, one or more instruction related to functions or operations for controlling each of the components, and a memory means for storing therein the instructions, treating recipes, and various data. The control device may further include a user interface including an input means used for the operator to input commands to manage the semiconductor manufacturing equipment 100, an output means to visualize and display the operating status of the semiconductor manufacturing equipment 100, etc. The control device may be provided as a computing device for data processing and analysis, command transmission, etc.

The instructions may be provided in a form of a computer program or application. The computer program may include one or more instructions and may be stored in a non-transitory computer-readable recording medium. The instructions may include code generated by a compiler, code that may be executed by an interpreter, etc. The memory means may be provided as a flash memory, hard disk drive (HDD), solid state disk (SSD), card type memory, random access memory (RAM), static random access memory (SRAM), read only memory (ROM), electrically erasable programable read only memory (EEPROM), programable read only memory (PROM), magnetic memory, magnetic disk, and optical disk.

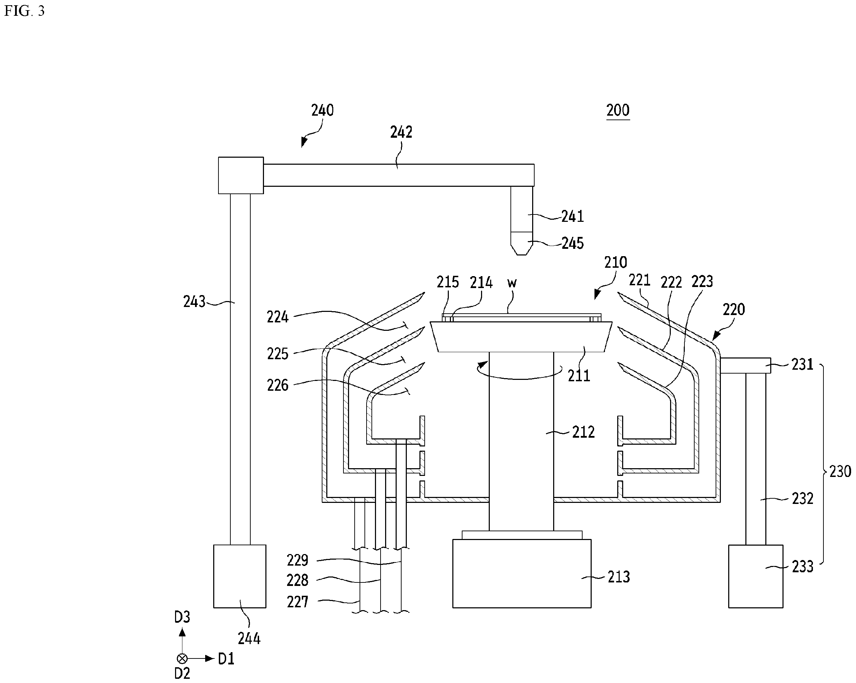

Next, the first process chamber 200 will be described. FIG. 3 is a schematic diagram illustrating a process chamber according to embodiments of the present disclosure. Referring to FIG. 3, the first process chamber 200 may be configured to include a support 210, a collector 220, a vertically-moving means 230, and a sprayer 240.

The first process chamber 200 may clean the substrate using a chemical. The first process chamber 200 may rotate the substrate using a spin head and provide the chemical on the substrate using a nozzle. The first process chamber 200 may be provided as a cleaning process chamber. The chemical may be a substance in a liquid state or a substance in a gaseous state. For example, when the chemical is a liquid substance, it may be an organic solvent. The chemical may include a substance that is highly volatile, and produces a lot of fumes or has a high viscosity and thus is highly residual. For example, the chemical may include an IPA (IsoPropyl Alcohol) component, a sulfuric acid component, an ammonium hydroxide component, a hydrofluoric acid component, a phosphoric acid component, etc. For example, when the chemical includes a sulfuric acid component, it may be a Sulfuric Peroxide Mix (SPM) containing a sulfuric acid component and a hydrogen peroxide component. For example, when the chemical is a substance containing ammonium hydroxide, it may be APM (Ammonia-Hydrogen Peroxide Mixture), which is an SC-1 cleaning solution. For example, when the chemical is a substance containing hydrofluoric acid, it may be DHF (Diluted Hydrogen Fluoride).

The support 210 supports the substrate W thereon. The support 210 may rotate the substrate W in the horizontal directions D1 and D2 when treating the substrate W. The support 210 may be surrounded with the collector 220. The support 210 may include a spin head 211, a rotation shaft 212, a first driving module 213, a support pin 214, and a guide pin 215.

The spin head 211 rotates along the rotation direction of the rotation shaft 212. The spin head 211 may be provided in the same shape as the substrate W. However, the present embodiment is not necessarily limited thereto.

The rotation shaft 212 generates a rotational force using power provided from the first driving module 213. The rotation shaft 212 may rotate the spin head 211 and may rotate the substrate together with the spin head 211.

The support pin 214 and the guide pin 215 fix the substrate W on the spin head 211. The support pin 214 supports a lower surface of the substrate W, and the guide pin 215 supports a side surface of the substrate W. A plurality of support pins 214 and a plurality of guide pins 215 may be provided on the spin head 211. The plurality of support pins 214 may be arranged in an annular ring shape while being disposed on the spin head 211. The support pin 214 may support the substrate W so that the substrate W does not contact an upper surface of the spin head 211. The guide pin 215 may be provided as a chucking pin and may support the substrate W so that the substrate W does not come off the spin head 211 due to the rotation.

The collector 220 collects the chemical used to treat the substrate W. The chemicals collected by the collector 220 may be recycled. The collector 220 may include a plurality of collection containers. For example, the collector 220 may include three collection containers 221, 222, and 223, including a first collection container 221, a second collection container 222, and a third collection container 223. Each of the first collection container 221, the second collection container 222, and the third collection container 223 may be provided as a bowl.

Each of the first collection container 221, the second collection container 222, and the third collection container 223 may be provided in an annular ring shape. The first collection container 221 may surround the second collection container 222, and the second collection container 222 may surround the third collection container 223. The first collection container 221, the second collection container 222, and the third collection container 223 may collect different types of chemicals in a separate manner. For example, the first collection container 221 may collect a first chemical liquid, the second collection container 222 may collect a second chemical liquid, and the third collection container 223 may collect a rinse liquid. The rinse liquid may be isopropyl alcohol (IPA) or DIW (De-Ionized Water).

Each of the collection containers 221, 222, and 223 may include each of inlets 224, 225, and 226 through which the chemical flows, and each of outlets through which the chemical is discharged. The outlet of each of the collection containers 221, 222, and 223 may be connected to each of collection lines 227, 228, and 229. The collection lines 227, 228, and 229 may be connected to a recycling facility that treats the chemical so that the chemical is recyclable.

The vertically-moving means 230 vertically moves the collector 220. The vertically-moving means 230 may adjust a vertical level of the collector 220 before and after treating the substrate W. The vertically-moving means 230 may adjust the vertical level of the collector 220 depending on the type of the chemical provided on the substrate W, or may adjust the vertical level of the spin head 211 without adjusting the vertical level of the collector 220. In this case, the first process chamber 200 might not include the vertically-moving means 230. The vertical level adjustment of the spin head 211 may be achieved by the rotation shaft 212 and the first driving module 213.

The vertically-moving means 230 may include a bracket 231, a first vertically-movable shaft 232, and a second driving module 233. The bracket 231 may be fixed to an outer wall of the collector 220. The first vertically-movable shaft 232 may be connected to the bracket 231 and the second driving module 233. The first vertically-movable shaft 232 may move up or down using the power provided from the second driving module 233. The first vertically-movable shaft 232 may vertically move up or down the collector 220 through the bracket 231.

The sprayer 240 supplies the chemical onto the substrate W. The sprayer 240 may include a plurality of nozzles. The nozzles may supply different types of chemicals onto the substrate W, respectively. The sprayer 240 may be configured to include a nozzle structure 241, a nozzle support module 242, a second vertically-movable shaft 243, a third driving module 244, and a nozzle 245.

The nozzle structure 241 is installed at an end of the nozzle support module 242. The nozzle structure 241 may include a nozzle 245. There may be multiple nozzles 245. The nozzle structure 241 may be movable to a process position to discharge the chemical on the substrate W. The nozzle structure 241 may otherwise be movable to a standby position.

The nozzle support module 242 and the second vertically-movable shaft 243 may connect the nozzle structure 241 and the third driving module 244 to each other. A length direction of the nozzle support module 242 may be different from a length direction of the second vertically-movable shaft 243. The nozzle support module 242 may extend along its length in the horizontal direction D1 or D2, and the second vertically-movable shaft 243 may extend along its length in the vertical direction D3.

The third driving module 244 may elevate and lower the second vertically-movable shaft 243. The third driving module 244 may rotate the nozzle support module 242. The third driving module 244 may move the nozzle structure 241 to a process position or a standby position through the nozzle support module 242 and the second vertically-movable shaft 243.

The first process chamber 200 may further include a chemical supply. The chemical supply may be connected to the sprayer 240 to supply the chemical. The chemical supply may be directly connected to the nozzle structure 241, or may also be connected to the nozzle structure 241 through the nozzle support module 242.

The first process chamber 200 may be provided as a single type facility. The first process chamber 200 may treat the substrates W individually or sequentially treat a plurality of substrates. The first portion 150 may include the second process chamber 300 instead of the first process chamber 200. Alternatively, the first portion 150 may include both the first process chamber 200 and the second process chamber 300. The second process chamber 300 may be provided as a batch type facility. The second process chamber 300 may simultaneously treat a plurality of substrates. When the first portion 150 includes the second process chamber 300, the semiconductor manufacturing equipment 100 may be provided as a hybrid equipment.

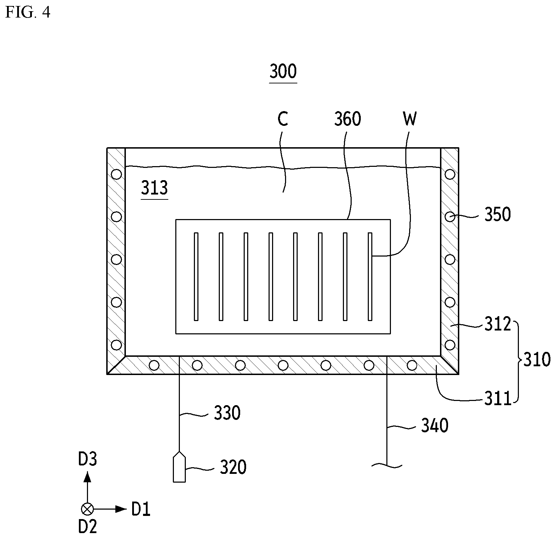

FIG. 4 is a schematic diagram illustrating a process chamber according to embodiments of the present disclosure. Referring to FIG. 4, the second process chamber 300 may be configured to include a treating bath 310, a treating liquid supply source 320, a treating liquid supply line 330, a treating liquid discharge line 340, and a temperature controller 350.

The second process chamber 300 may treat the plurality of substrates W stored in the storage container 360 by immersing the substrates W in the treating bath 310 in which the chemical C is stored. The second process chamber 300 may prewet the plurality of substrates W. The second process chamber 300 may etch the plurality of substrates W. The second process chamber 300 may rinse the plurality of substrates W. The chemical C may be a chemical solution with strong acid or strong base properties. For example, the chemical C may be the SC-1 cleaning solution Ammonium Hydroxide-Hydrogen Peroxide Mixture (APM), the SC-2 cleaning solution HPM (Hydrochloric acid-Hydrogen Peroxide Mixture), FPM (Hydrofluoric acid-Hydrogen Peroxide Mixture), Diluted Hydrofluoric Acid (DHF), a chemical solution to remove SiN, a chemical solution containing phosphoric acid, a chemical solution containing sulfuric acid, etc. The chemical C may be appropriately selected from IPA, DIW, or ozonated water.

The treating bath 310 may include an inner space 313 where the chemical C is stored. The inner space 313 may be defined by a bottom plate 311 and a side wall 312. The treating bath 310 may have a structure with an open upper surface.

The treating liquid supply source 320 supplies the chemical C. The treating liquid supply line 330 may connect the treating liquid supply source 320 to the inner space 313 of the treating bath 310. The treating liquid supply line 330 may introduce the chemical C supplied from the treating liquid supply source 320 into the inner space 313 of the treating bath 310. The treating liquid discharge line 340 may discharge the chemical C having been used for treating the substrate W to the outside.

The temperature controller 350 may control the temperature of the chemical C in the treating bath 310 by cooling or heating. For example, the temperature controller 350 may be a heater. The temperature controller 350 may be provided on each of the bottom plate 311 and the side wall 312 of the treating bath 310. The temperature controller 350 may be provided in the bottom plate 311, or may also be provided on a surface of the bottom plate 311. Likewise, the temperature controller 350 may be provided in the side wall 312, or may be provided on a surface of the side wall 312. The temperature controller 350 may be provided only on one of the bottom plate 311 and the side wall 312 of the treating bath 310.

Next, the third process chamber 400 will be described. The third process chamber 400 is a substrate treating apparatus and may dry the substrate W using the supercritical fluid. The substrate treating apparatus as described throughout the present disclosure refers to the third process chamber 400 that performs a drying process on the substrate W.

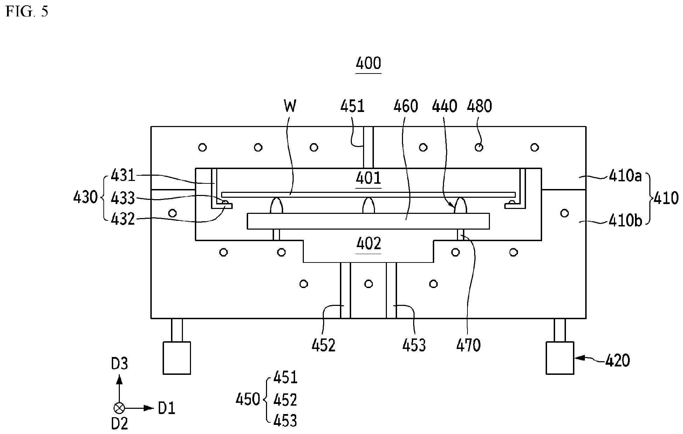

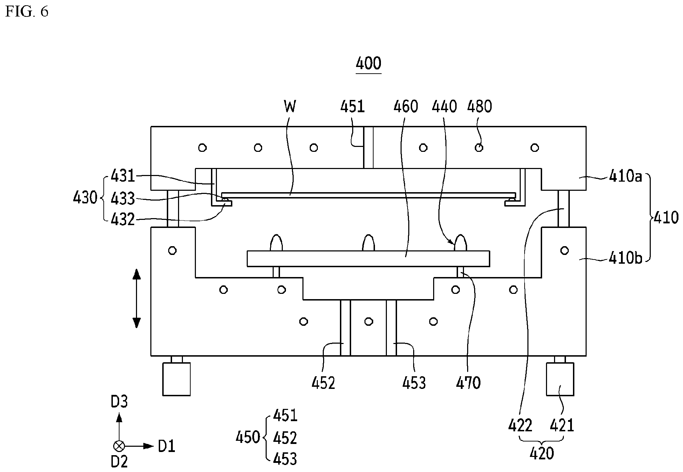

FIG. 5 and FIG. 6 are schematic diagrams illustrating a process chamber according to embodiments of the present disclosure. FIG. 5 shows a case where the third process chamber 400 is closed, and FIG. 6 shows a case where the third process chamber 400 is open. Referring to FIG. 5 and FIG. 6, the third process chamber 400 includes a chamber housing 410, a vertically-moving means 420, a second substrate support 430, a first substrate support 440, a supply and exhaust port 450, a shielding plate 460, a plate support 470, and a heater 480.

A supercritical process may include an etching process, a cleaning process, and a drying process using the supercritical fluid. The third process chamber 400 may perform a drying process using the supercritical fluid. The third process chamber 400 may dry the substrate W on which the rinse process has been completed. After the rinse process, the chemical may remain on the surface of the substrate W. The supercritical fluid may dry the substrate W by dissolving the chemical remaining on the substrate W. The supercritical fluid may be a substance that has temperature and pressure above a critical point, has diffusivity, viscosity, and surface tension like gas and has solubility like liquid. The supercritical fluid may include carbon dioxide (CO₂), water (H₂O), methane (CH₄), ethane (C₂H₆), propane (C₃H₈), ethylene (C₂H₄), propylene (C₂H₂), methanol (C₂H₃OH), ethanol (C₂H₅OH), sulfur hexafluoride (SF₆), acetone (C₃H₈O), etc. For example, the third process chamber 400 may use carbon dioxide (CO₂) in a supercritical state.

The chamber housing 410 may provide a treating space within which a supercritical drying process is performed. The treating space may include a process area 401 and a buffer area 402. The process area 401 may be located on top of the substrate W. The buffer area 402 may be located under the substrate W. The chamber housing 410 may be made of a material that may withstand high pressure above the critical pressure.

The chamber housing 410 may include an upper module 410a and a lower module 410b. The upper module 410a may include an upper wall and a first side wall. The upper wall of the upper module 410a may serve as the upper wall of the chamber housing 410. The first sidewall of the upper module 410a may be provided as a portion of the sidewall of the chamber housing 410. The lower module 410b may include a lower wall and a second side wall. The lower wall of the lower module 410b may serve as the lower wall of the chamber housing 410. The second side wall of the lower module 410b may be provided as a portion of the side wall of the chamber housing 410.

The upper module 410a may be fixed, and the lower module 410b may be raised and lowered or vertically movable. However, embodiments of the present disclosure are not necessarily limited thereto, and the upper module 410a may be vertically movable and the lower module 410b may be fixed. Alternatively, both the upper module 410a and the lower module 410b may be vertically movable. The chamber housing 410 may be opened or closed. The chamber housing 410 may be opened via removal of the upper module 410a and the lower module 410b from each other. In this case, the substrate W may be brought into the inner space of the chamber housing 410 or taken out from the inner space. The chamber housing 410 may be closed by combining the upper module 410a and the lower module 410b to each other. In this case, the substrate W may be treated in the inner space of the chamber housing 410. The substrate W being brought into the inner space of the chamber housing 410 may have the cleaning liquid remaining thereon. For example, the cleaning liquid may be IPA or DIW.

The vertically-moving means 420 may elevate or lower the upper module 410a or the lower module 410b. The vertically-moving means 420 may include a vertically-moving cylinder 421 and a vertically-moving rod 422. The vertically-moving cylinder 421 may generate a driving force. The upper module 410a or lower module 410b may move in the vertical direction D3 along the vertically-moving rod 422.

The second substrate support 430 may support the substrate W when the chamber housing 410 is opened. The second substrate support 430 may support the substrate W when the substrate W is brought in or taken out. The first substrate support 440 may support the substrate W when the chamber housing 410 is closed. The first substrate support 440 may support the substrate W when treating the substrate W in the inner space of the chamber housing 410.

The second substrate support 430 may include a vertical rod 431, a horizontal rod 432, and a support protrusion 433. The vertical rod 431 may extend in the vertical direction D3 from the upper wall of the upper module 410a. The horizontal rod 432 may extend in the horizontal direction D1 from an end of the vertical rod 431. The support protrusion 433 may be formed on the horizontal rod 432. A plurality of second substrate supports 430 may be provided. The second substrate support 430 may support the substrate W at a position spaced apart from the upper wall of the upper module 410a.

When the chamber housing 410 is closed, the first substrate support 440 may support the substrate W at a higher position than that of the second substrate support 430. The second substrate support 430 does not support the substrate W, and only the first substrate support 440 may support the substrate W. When the chamber housing 410 is closed, the first substrate support 440 may support the substrate W at the same position as that of the second substrate support 430. The second substrate support 430 and the first substrate support 440 may simultaneously support the substrate W. A plurality of first substrate supports 440 may be provided.

The third process chamber 400 may further include a levelness adjustment module. The levelness adjustment module may be installed in the upper module 410a. The levelness adjustment module may adjust a levelness of the upper module 410a. The levelness adjustment module may adjust the levelness of the substrate W supported by the second substrate support 430. However, embodiments of the present disclosure are not necessarily limited thereto, and the levelness adjustment module may also be installed in the lower module 410b. The levelness adjustment module may adjust the levelness of the lower module 410b. The levelness adjustment module may adjust the levelness of the substrate W supported by the first substrate support 440.

The supply and exhaust port 450 may include a first supply port 451, a second supply port 452, and an exhaust port 453. The first supply port 451 may be provided in the upper module 410a. The first supply port 451 may extend through the upper wall of the upper module 410a. The first supply port 451 may provide the supercritical fluid to the process area 401. The second supply port 452 may be provided in the lower module 410b. The second supply port 452 may extend through the lower wall of the lower module 410b. The second supply port 452 may provide the supercritical fluid to the buffer area 402.

The second supply port 452 may provide the supercritical fluid first, and then, the first supply port 451 may provide the supercritical fluid later. When the internal temperature and internal pressure of the chamber housing 410 reach the critical temperature and critical pressure, the first supply port 451 may provide the supercritical fluid. This may prevent the supercritical fluid provided through the first supply port 451 from being liquefied and falling on the substrate W, thereby damaging the substrate W.

The exhaust port 453 may discharge the fluid used for treating the substrate W into the atmosphere from the inner space of the chamber housing 410. The exhaust port 453 may discharge the fluid used in treating the substrate W to a regeneration system. The fluid used for the treatment of the substrate W may contain the chemical. The regeneration system may separate the fluid into supercritical fluid and the chemical. The exhaust port 453 may be provided in the lower module 410b.The exhaust port 453 may extend through the lower wall of the lower module 410b. The exhaust port 453 may be adjacent to the second supply port 452.

The shielding plate 460 may be provided in the inner space of the chamber housing 410. The shielding plate 460 may prevent the supercritical fluid provided through the second supply port 452 from being directly sprayed onto the lower surface of the substrate W. The first substrate support 440 may be provided on the shielding plate 460. The process area 401 and the buffer area 402 may be distinguished from each other by the shielding plate 460.

The shielding plate 460 may be disposed on the lower wall of the lower module 410b. The shielding plate 460 may be supported by the plate support 470. The shielding plate 460 might not contact the lower wall of the lower module 410b due to the plate support 470. The shielding plate 460 may be formed in a shape corresponding to the substrate W. The plate support 470 may be provided in a plural manner.

The heater 480 may heat the inner space of the chamber housing 410. The heater 480 may maintain the supercritical fluid supplied to the inner space of the chamber housing 410 to a temperature above the critical temperature. The heater 480 may change the liquefied fluid back into a fluid in a supercritical state. The heater 480 may be provided in a plural manner. The heater 480 may be provided in each of the upper module 410a and the lower module 410b. However, embodiments of the present disclosure are not necessarily limited thereto, and the heater 480 may be provided in any one of the upper module 410a and the lower module 410b. For example, the heater 480 may be provided as an electrical heater.

When a cleaning process is performed using the chemical, pattern collapse may occur due to the influence of a surface tension existing between liquid films. The supercritical drying process may be used to solve this problem. When the cleaning process is completed, the substrate W may be wetted with the cleaning solution. For example, the cleaning fluid may be IPA. Using the supercritical drying process, the supercritical fluid with a low surface tension may be input into a sealed chamber in a pressed manner and thus may be mixed with the IPA between the patterns within the substrate W, thereby minimizing the surface tension to prevent the pattern collapse.

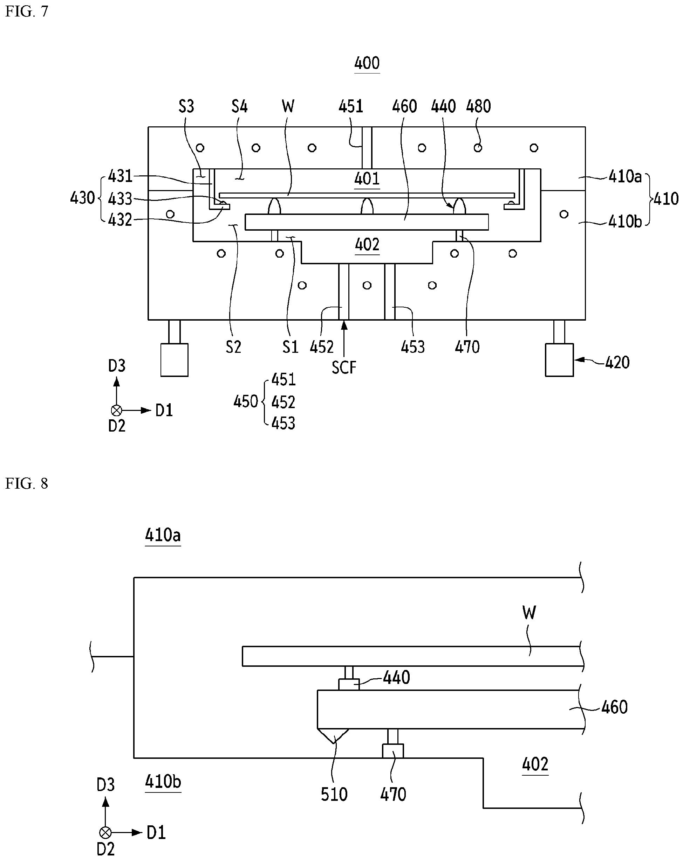

At the beginning of the drying process, the second supply port 452 may provide the supercritical fluid. Referring to FIG. 7, the supercritical fluid SCF may sequentially flow through the buffer area 402, the first space S1 under the shielding plate 460, the second space S2 under the substrate W and then may reach a fourth space S4 on top of the substrate W. However, because the supercritical fluid SCF flows into the second space S2 which is abruptly wider than the first space S1, the turbulent flow may occur near the edge of the substrate W, which may cause the pattern to be subj ected to shear stress. The shear stress caused by the turbulent flow may cause the pattern collapse in the edge area of the substrate W.

The third process chamber 400 may apply a throat structure to a flow path of the supercritical fluid. The third process chamber 400 may apply the throat structure to the first space S1. The throat structure may narrow a width of the supercritical fluid's flow path and then widen the width thereof. When the throat structure is applied to the first space S1, the supercritical fluid SCF may reach the fourth space S4 through a third space S3 adjacent to the inner wall of the chamber housing 410. The throat structure applied to the first space S1 may weaken the turbulent flow acting near the edge of the substrate W and reduce the flow velocity near the edge of the substrate W. The throat structure applied to the first space S1 may control the generation of the turbulent flow. The throat structure may minimize or eliminate the turbulent flow. When the generation of the turbulent flow is controlled using the throat structure, the third process chamber 400 may improve the flow distribution and reduce the shear stress near the edge of the substrate W, which is most vulnerable to the pattern collapse. The third process chamber 400 may prevent the pattern collapse from occurring in the edge area of the substrate W. FIG. 7 is a schematic diagram illustrating an effect of the throat structure according to embodiments of the present disclosure.

The throat structure may include a single protrusion. For example, the throat structure may include a first protrusion 510. Referring to FIG. 8, the first protrusion 510 may be formed on an end of a lower surface of the shielding plate 460. The position of the first protrusion 510 is not necessarily limited thereto, and the first protrusion 510 may be formed anywhere on the lower surface of the shielding plate 460 in the first space S1. However, the first protrusion 510 formed at the end of the lower surface of the shielding plate 460 may be most advantageous in controlling the occurrence of the turbulent flow. FIG. 8 is a schematic diagram illustrating the throat structure according to embodiments of the present disclosure.

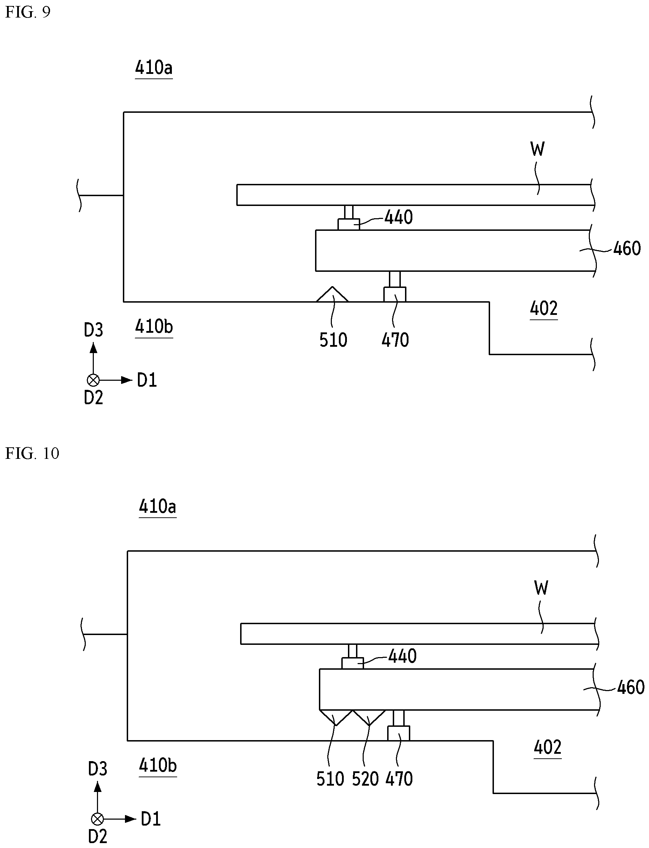

The present disclosure is not necessarily limited to a construction that the first protrusion 510 is formed on the shielding plate 460. The first protrusion 510 may also be formed on the lower module 410b. Referring to FIG. 9, the first protrusion 510 may be formed in a position adjacent to the end of the lower surface of the shielding plate 460. The first protrusion 510 may be formed at a position facing the end of the lower surface of the shielding plate 460. The position of the first protrusion 510 is not necessarily limited thereto, and the first protrusion may be formed anywhere on the inner surface of the lower module 410b within the first space S 1. However, the first protrusion 510 formed at the position facing the end of the lower surface of the shielding plate 460 may be most advantageous in controlling the occurrence of turbulent flow. FIG. 9 is a schematic diagram illustrating the throat structure according to embodiments of the present disclosure.

The first protrusion 510 may have a triangular cross section. However, embodiments of the present disclosure are not necessarily limited thereto, and the first protrusion 510 may have a cross-section of various polygonal shapes, including a square shape. Alternatively, the first protrusion 510 may have a semicircular or semielliptical cross section.

The throat structure may include a plurality of protrusions. For example, the throat structure may include a first protrusion 510 and a second protrusion 520. The first protrusion 510 and the second protrusion 520 may be formed on the shielding plate 460. The first protrusion 510 and the second protrusion 520 may be adjacent to each other. Within the first space S1, the first protrusion 510 and the second protrusion 520 may be adjacent to each other anywhere in the lower surface of the shielding plate 460. For example, referring to FIG. 10, the first protrusion 510 and the second protrusion 520 may be adjacent to each other at the end of the lower surface of the shielding plate 460. FIG. 10 is a schematic diagram illustrating the throat structure according to embodiments of the present disclosure.

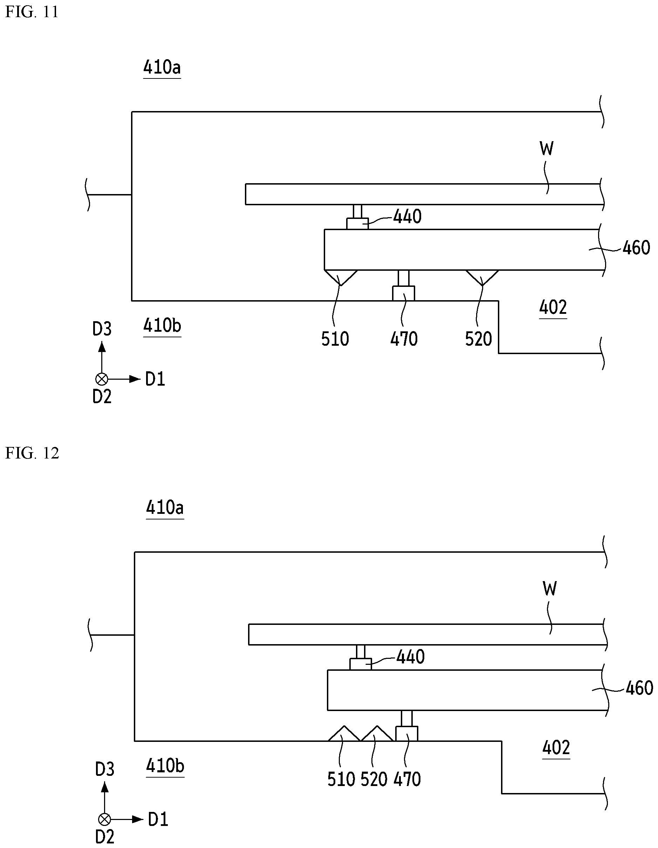

However, embodiments of the present disclosure are not necessarily limited thereto, and the first protrusion 510 and the second protrusion 520 may also be spaced apart from each other. When within the first space S1, the first protrusion 510 and the second protrusion 520 may be spaced apart from each other anywhere on the lower surface of the shielding plate 460. For example, referring to FIG. 11, the first protrusion 510 may be formed at the end of the lower surface of the shielding plate 510, and the second protrusion 520 may be formed on the lower surface of the shielding plate 510 and at a position adj acent to the buffer area 402. When the throat structure includes a plurality of protrusions, it is preferable that at least one protrusion is formed on the end of the lower surface of the shielding plate 460. FIG. 11 is a schematic diagram illustrating the throat structure according to embodiments of the present disclosure.

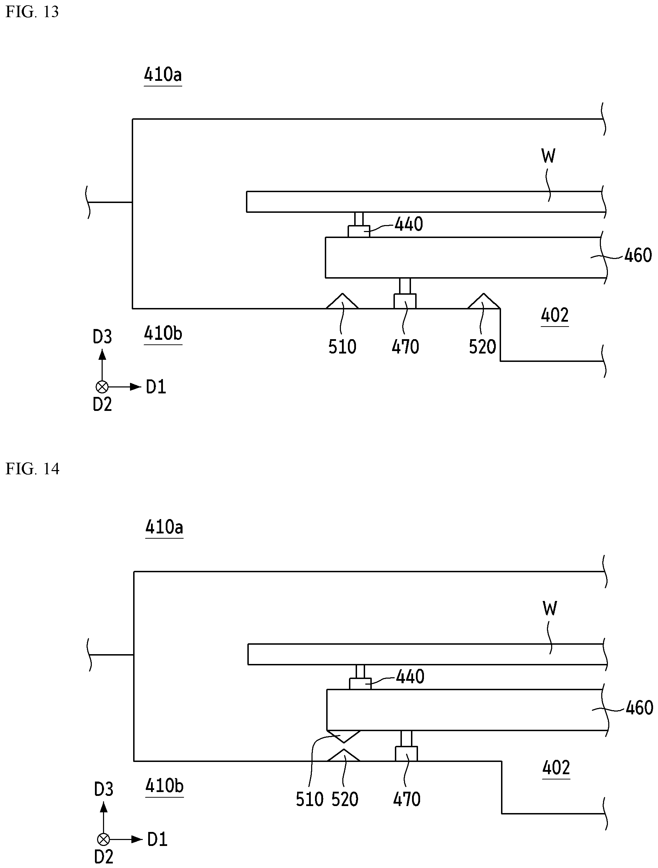

The present disclosure is not necessarily limited to the construction that the first protrusion 510 and the second protrusion 520 are formed on the shielding plate 460. The first protrusion 510 and the second protrusion 520 may also be formed on the lower module 410b. The first protrusion 510 and the second protrusion 520 may be adjacent to each other. Alternatively, the first protrusion 510 and the second protrusion 520 may be spaced apart from each other. Within the first space S1, the first protrusion 510 and the second protrusion 520 may be adjacent to each other or spaced apart from each other anywhere on the inner surface of the lower module 410b. For example, referring to FIG. 12, the first protrusion 510 and the second protrusion 520 may be adjacent to each other in an area facing the end of the lower surface of the shielding plate 460. For example, referring to FIG. 13, the first protrusion 510 may be formed in the position facing the end of the lower surface of the shielding plate 510, and the second protrusion 520 may be formed in the position facing the lower surface of the shielding plate 510 and at a position adjacent to the buffer area 402. When the throat structure includes a plurality of protrusions, it is preferable that at least one protrusion is formed in a position facing the end of the lower surface of the shielding plate 460. FIG. 12 is schematic diagram illustrating the throat structure according to embodiments of the present disclosure. FIG. 13 is a schematic diagram illustrating the throat structure according to embodiments of the present disclosure.

All of the first protrusion 510 and the second protrusion 520 may be disposed on one of the shielding plate 460 and the lower module 410b. The first protrusion 510 may be formed on the shielding plate 460, and the second protrusion 520 may be formed on the lower module 410b. The first protrusion 510 may be formed anywhere on the lower surface of the shielding plate 460 and in the first space S1, and the second protrusion 520 may be formed anywhere on the inner surface of the lower module 410b and in the first space S1. The first protrusion 510 and the second protrusion 520 may be formed at positions overlapping each other in the vertical direction D3, respectively. For example, referring to FIG. 14, the first protrusion 510 may be formed on the end of the lower surface of the shielding plate 460, and the second protrusion 520 may be formed on the inner surface of the lower module 410b and at a position facing the end of the lower surface of the shielding plate 460. FIG. 14 is a schematic diagram illustrating the throat structure according to embodiments of the present disclosure.

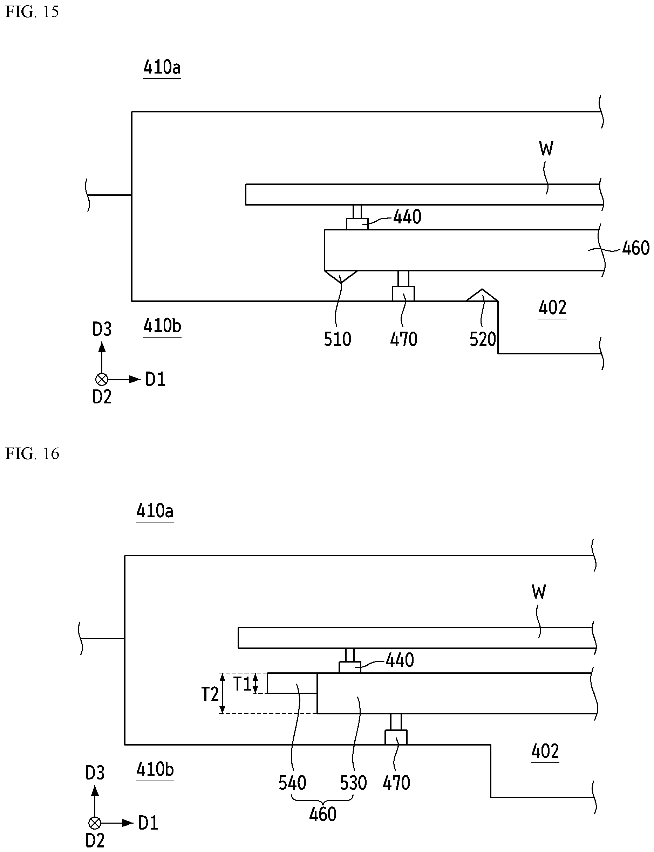

The first protrusion 510 and the second protrusion 520 may be respectively formed at positions that do not overlap each other in the vertical direction D3. In one example, referring to FIG. 15, the first protrusion 510 may be formed on the end of the lower surface of the shielding plate 460, and the second protrusion 520 may be formed on the inner surface of the lower module 410b and at a position adjacent to the buffer area 402 facing the lower surface of the shielding plate 510. Alternatively, the first protrusion 510 may be formed in the lower surface of the shielding plate 510 and at a position adjacent to the buffer area 402, and the second protrusion 520 may be formed on the inner surface of the lower module 410b and at a position facing the end of the lower surface of the shielding plate 460. When the throat structure includes a plurality of protrusions, it is preferable that at least one protrusion is formed on the end of the lower surface of the shielding plate 460 or in the position facing the end of the lower surface of the shielding plate 460. FIG. 15 is a schematic diagram illustrating the throat structure according to embodiments of the present disclosure.

The first protrusion 510 and the second protrusion 520 may have cross-sections of the same shape. However, embodiments of the present disclosure are not necessarily limited thereto, and the first protrusion 510 and the second protrusion 520 may have cross-sections of different shapes. Each of the cross section of the first protrusion 510 and the cross section of the second protrusion 520 may be selected from a polygonal shape, a semicircular shape, and a semielliptical shape, but are not necessarily limited thereto.

The third process chamber 400 may control the generation of the turbulent flow through the throat structure. However, the present disclosure is not necessarily limited thereto. The third process chamber 400 may also control the generation of the turbulent flow using at least one component selected from the shielding plate 460, the first substrate support 440, and the plate support 470. Hereinafter, this configuration is described.

FIG. 16 is a schematic diagram illustrating a structure of a shielding plate according to embodiments of the present disclosure. Referring to FIG. 16, the shielding plate 460 may be configured to include a plate body 530 and a length extension 540. The length extension 540 may be coupled to an outer side surface of the plate body 530. The plate body 530 may have a circular shape in a plan view, and the length extension 540 may have an annular ring shape in a plan view. However, the shapes of the plate body 530 and length extension 540 are not necessarily limited thereto.

A length of the plate body 530 does not change, while a length of the length extension 540 from the outer side surface of the plate body 530 in an outward direction D1 and D2 may vary. The length of the length extension 540 may change depending on a process condition. For example, the length of the length extension 540 may change depending on a process temperature, a process pressure, etc. Alternatively, the length of the length extension 540 may change depending on a process type. The length of the length extension 540 may change before starting the drying process.

The length extension 540 may be made of the same material as that of the plate body 530. For example, the plate body 530 and the length extension 540 may be made of the same metal or alloy. However, embodiments of the present disclosure are not necessarily limited thereto, and the length extension 540 may be made of a different material from that of the plate body 530. For example, the plate body 530 and the length extension 540 may be made of different metals or alloys. Alternatively, the plate body 530 may be made of metal, and the length extension 540 may be made of a polymer that replaces the metal. When the length extension 540 is made of metal, the length extension may be made of SUS (Stainless Use Steel) or STS (Steel Type Stainless). When the length extension 540 is made of polymer, the length extension may be made of PEEK (polyetheretherketone).

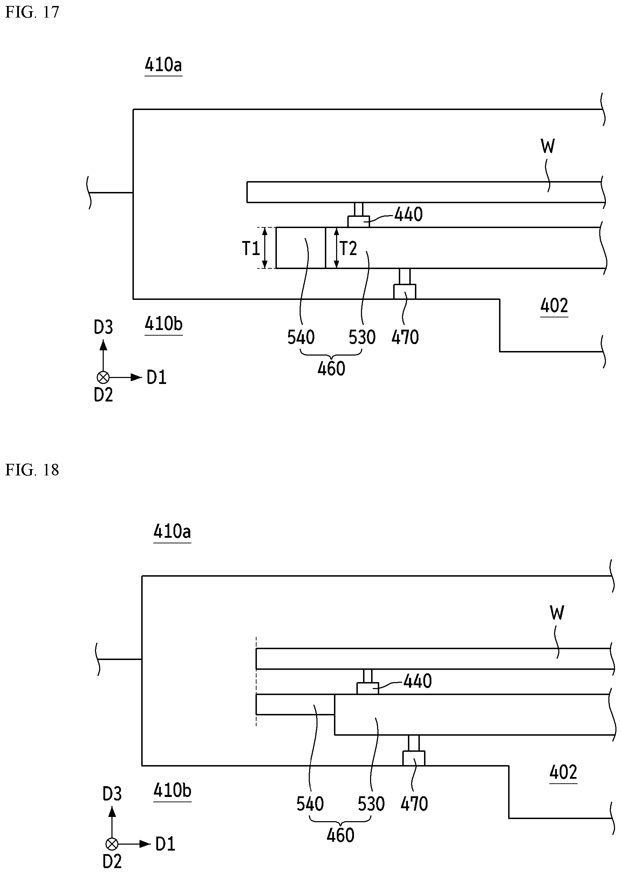

A thickness T1 of the length extension 540 may be smaller than a thickness T2 of the plate body 530 (T1<T2). However, embodiments are not necessarily limited thereto. Referring to FIG. 17, the thickness T1 of the length extension 540 may be equal to the thickness T2 of the plate body 530 (T1 = T2). FIG. 17 is a schematic diagram illustrating the structure of the shielding plate according to embodiments of the present disclosure.

Referring again to FIG. 16, a distal end of the length extension 540 may be located inwardly of a distal end of the substrate W. For example, the shielding plate 460 composed of the plate body 530 and the length extension 540 may have a width smaller than that of the substrate W. However, this embodiment is not necessarily limited thereto.

Referring to FIG. 18, the distal end of the length extension 540 may be aligned with the distal end of the substrate W in the third direction D3. For example, the shielding plate 460 composed of the plate body 530 and the length extension 540 may have the same width as that of the substrate W. FIG. 18 is a schematic diagram illustrating the structure of the shielding plate according to embodiments of the present disclosure.

The distal end of the length extension 540 is not positioned outwardly of the distal end of the substrate W. For example, if the shielding plate 460 composed of the plate body 530 and the length extension 540 has a width greater than that of the substrate W, the generation of turbulent flow may be strengthened, which may increase the shear stress experienced by the edge area of the substrate W. In this embodiment, the distal end of the length extension 540 may be aligned with the distal end of the substrate W in the vertical direction, or may be located inwardly of the distal end of the substrate W. For example, the distal end of the length extension 540 may be located inwardly of the distal end of the substrate W.

Referring again to FIG. 16, the length extension 540 may have a constant thickness. The length extension 540 might not include an inclined lower surface. However, embodiments of the present disclosure are not necessarily limited thereto, and the thickness of the length extension 540 may be gradually reduced as the length extension extends toward the inner wall of the chamber housing 410.The length extension 540 may include an inclined lower surface.

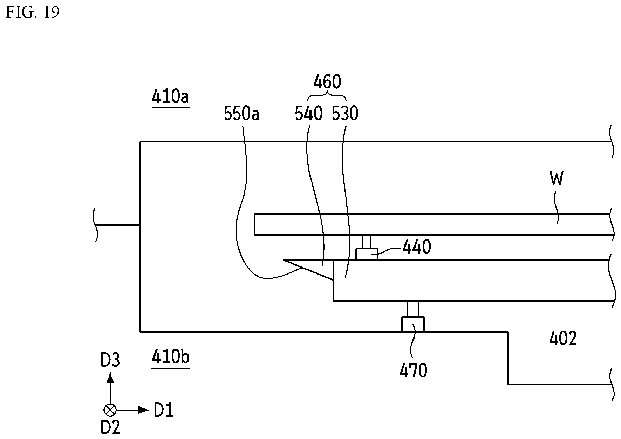

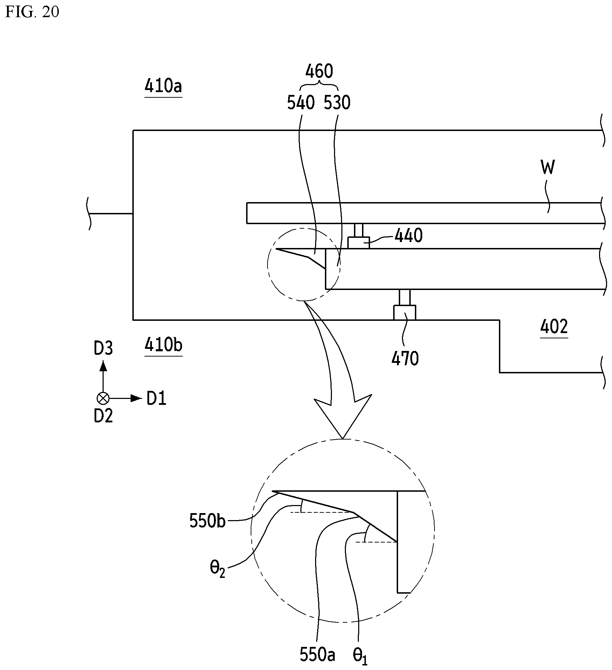

The inclined surface of the length extension 540 may be formed as a single straight line surface. Referring to FIG. 19, the length extension 540 may include a first inclined surface 550a as a first straight line surface. However, embodiments of the present disclosure are not necessarily limited thereto, and the inclined surface of the length extension 540 may also be formed as a plurality of straight line surfaces. For example, the inclined surface of the length extension 540 may include a first inclined surface 550a formed as a first straight line surface and a second inclined surface 550b formed as a second straight line surface. Referring to FIG. 20, an inclination angle θ1 of the first inclined surface 550a may be greater than an inclination angle θ2 of the second inclined surface 550b (θ1>θ2). The inclination angle θ1 of the first inclined surface 550a may be smaller than that of the inclination angle θ2 of the second inclined surface 550b (θ1<θ2). FIG. 19 is a schematic diagram illustrating the structure of the shielding plate according to embodiments of the present disclosure. FIG. 20 is a schematic diagram illustrating the structure of the shielding plate according to embodiments of the present disclosure.

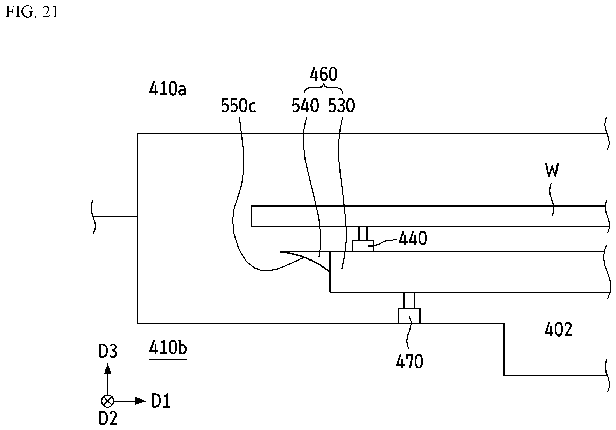

The inclined surface of the length extension 540 is not necessarily limited to being formed as a straight line surface, and may also be formed as a curved surface. The inclined surface of the length extension 540 may be formed as a single curved surface. Referring to FIG. 21, the length extension 540 may include a third inclined surface 550c formed as a first curved surface. The third inclined surface 550c may be formed as a concavely curved surface. The third inclined surface 550c may also be formed as a convexly curved surface. FIG. 21 is a schematic diagram illustrating the structure of the shielding plate according to embodiments of the present disclosure.

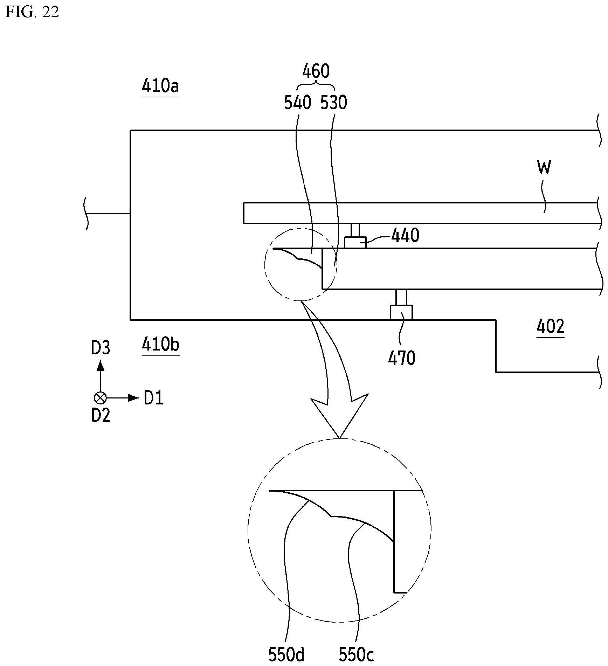

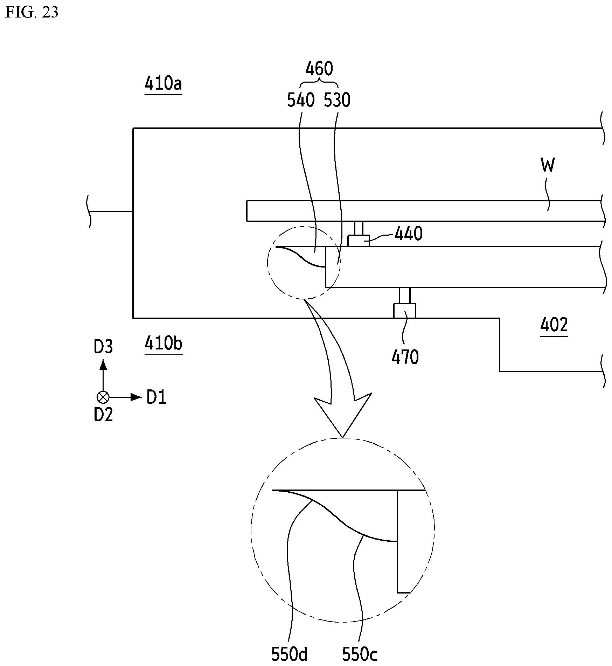

However, embodiments of the present disclosure are not necessarily limited thereto, and the inclined surface of the length extension 540 may also be formed as a plurality of curved surfaces. For example, the inclined surface of the length extension 540 may include a third inclined surface 550c formed as a first curved surface and a fourth inclined surface 550d formed as a second curved surface. The third inclined surface 550c and the fourth inclined surface 550d may be formed in the same shape. Referring to FIG. 22, each of the third inclined surface 550c and the fourth inclined surface 550d may be formed in a concavely curved shape. Each of the third inclined surface 550c and the fourth inclined surface 550d may be formed in a convexly curved shape. Alternatively, the third inclined surface 550c and the fourth inclined surface 550d may be formed in different shapes. Referring to FIG. 23, the third inclined surface 550c may be formed in a convexly curved shape, and the fourth inclined surface 550d may be formed in a concavely curved shape. The third inclined surface 550c may be formed in a concavely curved shape, and the fourth inclined surface 550d may be formed in a convexly curved shape. FIG. 22 is a schematic diagram illustrating the structure of the shielding plate according to embodiments of the present disclosure. FIG. 23 is a schematic diagram illustrating the structure of the shielding plate according to embodiments of the present disclosure.

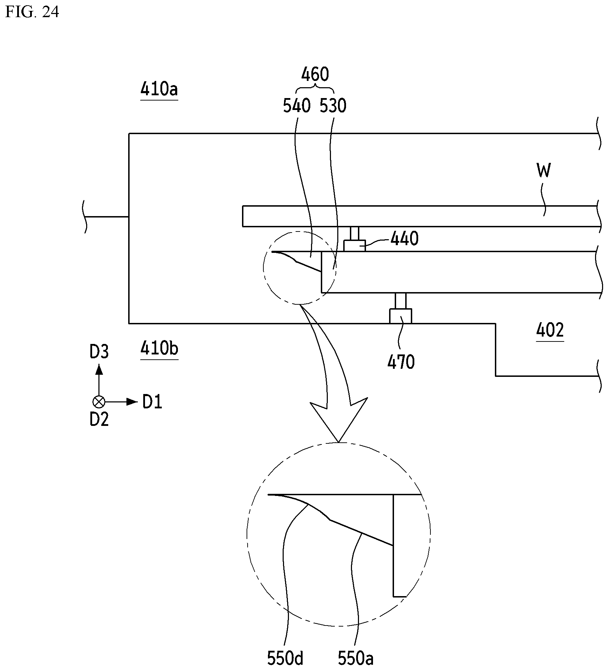

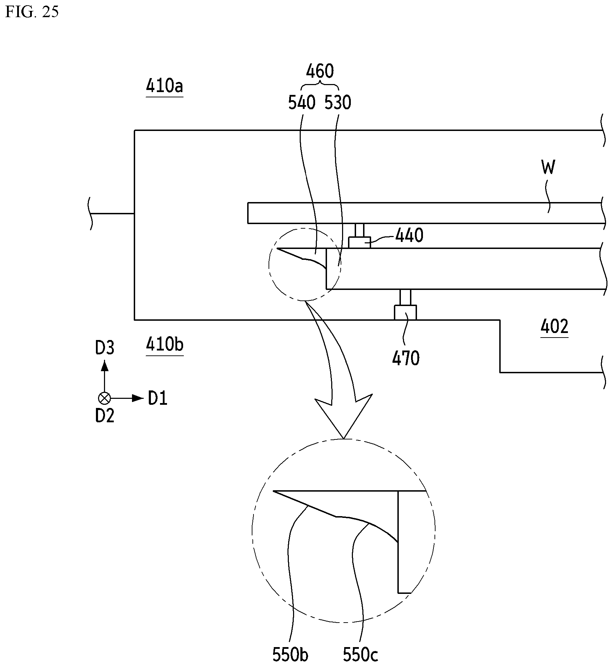

The inclined surface of the length extension 540 is not necessarily limited to being formed as either a straight line surface or a curved surface, and may also include both the straight line surface and the curved surface. Referring to FIG. 24, the inclined surface of the length extension 540 may include a first inclined surface 550a formed as a first straight line surface and a fourth inclined surface 550d formed as a second curved surface. The fourth inclined surface 550d may be formed in a concavely curved shape. The fourth inclined surface 550d may also be formed in a convexly curved shape. Alternatively, referring to FIG. 25, the inclined surface of the length extension 540 may include a third inclined surface 550c formed as a first curved surface and a second inclined surface 550b formed as a second straight line surface. The third inclined surface 550c may be formed in a concavely curved shape. The third inclined surface 550c may also be formed in a convexly curved shape. FIG. 24 is a schematic diagram illustrating the structure of the shielding plate according to embodiments of the present disclosure. FIG. 25 is a schematic diagram illustrating the structure of the shielding plate according to embodiments of the present disclosure.

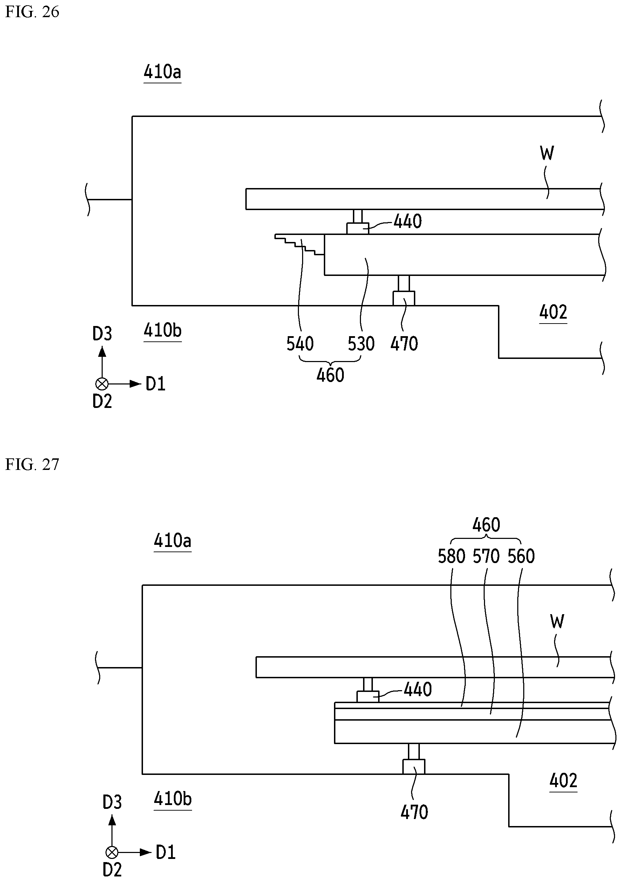

In one example, referring to FIG. 26, the inclined surface of the length extension 540 may also be formed in a stepped shape. FIG. 26 is a schematic diagram illustrating the structure of the shielding plate according to embodiments of the present disclosure.

The throat structure has been described above with reference to FIGS. 8 to 15. When the length extension 540 does not include the inclined surface, the throat structure may be applied to the length extension 540. When the length extension 540 includes the inclined surface, the throat structure may be applied to the plate body 530.

The shielding plate 460 is not necessarily limited to being formed as a single layer, and may also be formed as a plurality of layers. In one example, referring to FIG. 27, the shielding plate 460 may be configured to include a filler body 560, a filler volume increasing plate 570, and a filler cap 580. FIG. 27 is a schematic diagram illustrating the structure of the shielding plate according to embodiments of the present disclosure.

Each of the filler body 560, filler volume increasing plate 570, and the filler cap 580 may be made of metal. For example, each of the filler body 560, the filler volume increasing plate 570, and the filler cap 580 may be made of SUS or STS. The filler volume increasing plate 570 may be stacked on the filler body 560, and the filler cap 580 may be stacked on the filler volume increasing plate 570. The filler cap 580 is provided as a cap covering a top of the filler body 560. The filler volume increasing plate 570 is disposed under the filler cap 580 and serves as a plate that substantially contributes to increasing the volume of the shielding plate 460. Each of the filler volume increasing plate 570 and the filler cap 580 may be made of the same material as that of the filler body 560. For example, the filler body 560, the filler volume increasing plate 570, and the filler cap 580 may be made of the same metal or alloy. However, embodiments of the present disclosure are not necessarily limited thereto, and each of the filler volume increasing plate 570 and the filler cap 580 may be made of a different material from that of the filler body 560. For example, each of the filler volume increasing plate 570 and the filler cap 580 may be made of a different metal or alloy than that of the filler body 560. Alternatively, the filler body 560 may be made of metal, and each of the filler volume increasing plate 570 and the filler cap 580 may be made of a polymer that replaces the metal. When each of the filler volume increasing plate 570 and the filler cap 580 is made of metal, the metal may include SUS or STS. When each of the filler volume increasing plate 570 and the filler cap 580 is made of polymer, the polymer may include PEEK. In one example, the filler volume increasing plate 570 and the filler cap 580 may be made of the same material, or may also be made of different materials.

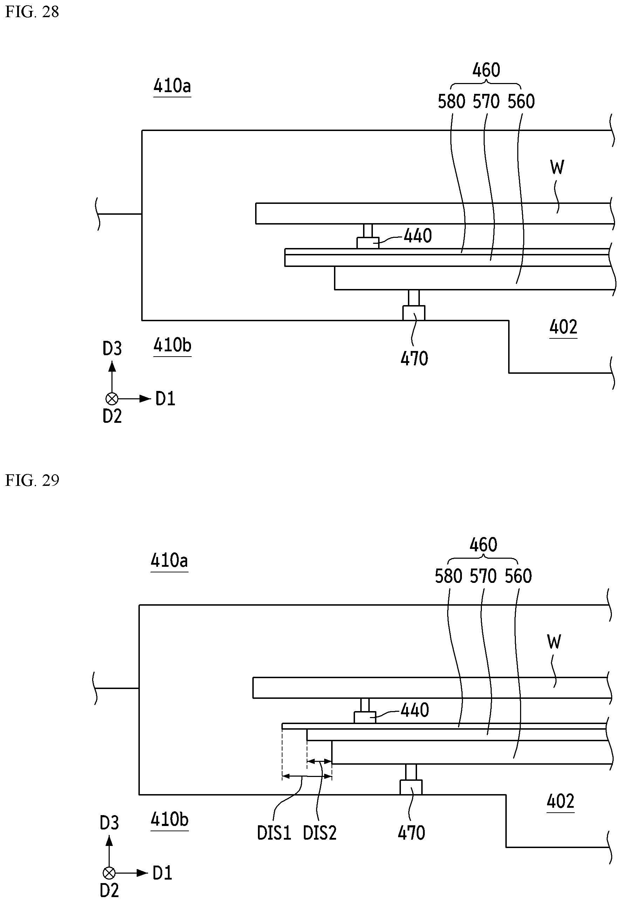

The filler body 560 may be fixed onto the plate support 470, while the filler volume increasing plate 570 and the filler cap 580 may be movable in the horizontal direction D1 and D2. Referring to FIG. 28, the filler volume increasing plate 570 and the filler cap 580 may be movable on the filler body 560 and toward the inner wall of the chamber housing 410. A moving distance of each of the filler volume increasing plate 570 and the filler cap 580 may vary depending on the process conditions. For example, the moving distance of each of the filler volume increasing plate 570 and the filler cap 580 may vary depending on the process temperature, process pressure, etc. Alternatively, the moving distance of each of the filler volume increasing plate 570 and the filler cap 580 may vary depending on the process type. The filler volume increasing plate 570 and the filler cap 580 may be movable before starting the drying process. FIG. 28 is a schematic diagram illustrating the structure of the shielding plate according to embodiments of the present disclosure.

The filler volume increasing plate 570 and the filler cap 580 may be movable independently of each other. The moving distance of the filler cap 580 may be equal to the moving distance of the filler volume increasing plate 570. However, embodiments of the present disclosure are not necessarily limited thereto, and the moving distance of the filler cap 580 may be different from the moving distance of the filler volume increasing plate 570. Referring to FIG. 29, the moving distance DIS1 of the filler cap 580 may be larger than the moving distance DIS2 of the filler volume increasing plate 570 (DIS1>DIS2). FIG. 29 is a schematic diagram illustrating the structure of the shielding plate according to embodiments of the present disclosure.

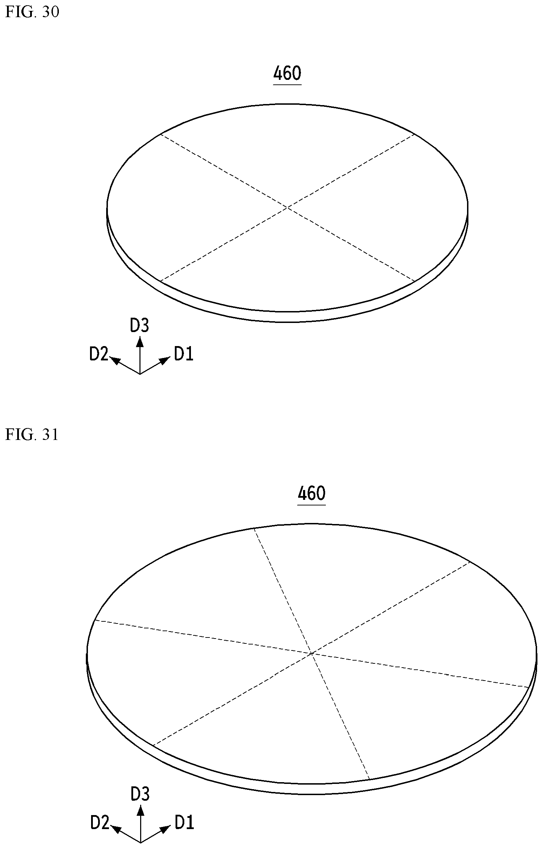

Each of the filler volume increasing plate 570 and the filler cap 580 may be divided into a plurality of portions. Each of the filler volume increasing plate 570 and the filler cap 580 may be divided into the portions in an equal manner. Each of the filler volume increasing plate 570 and the filler cap 580 may be divided into an even number of portions. For example, referring to FIG. 30, each of the filler volume increasing plate 570 and the filler cap 580 may be divided into four portions. In an example, referring to FIG. 31, each of the filler volume increasing plate 570 and the filler cap 580 may be divided into six portions. However, embodiments of the present disclosure are not necessarily limited thereto, and each of the filler volume increasing plate 570 and the filler cap 580 may also be divided into an odd number of portions. The filler volume increasing plate 570 and the filler cap 580 may be divided into the same number of portions, or may also be divided into different numbers of portions. FIG. 30 is a schematic diagram illustrating the structure of the shielding plate according to embodiments of the present disclosure. FIG. 31 is a schematic diagram illustrating the structure of the shielding plate according to embodiments of the present disclosure.

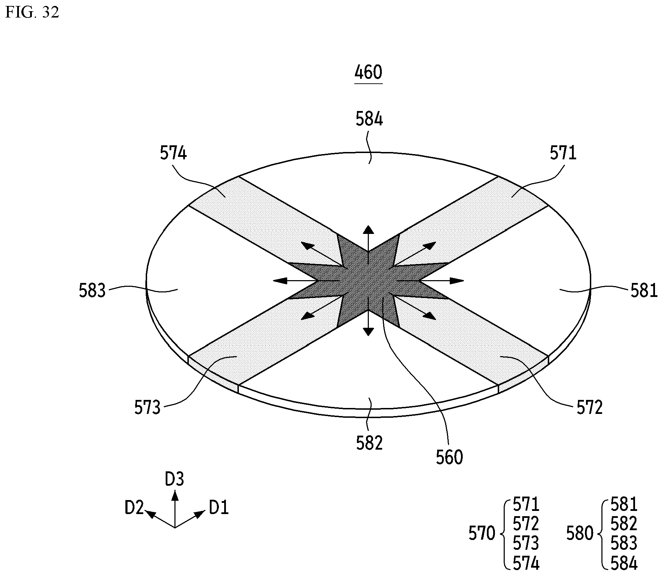

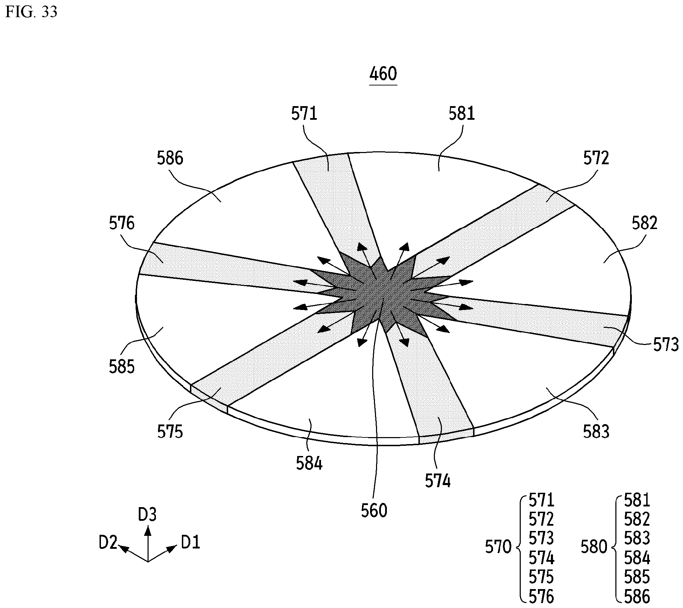

When each of the filler volume increasing plate 570 and the filler cap 580 are divided into the plurality of portions, the plurality of portions of the filler volume increasing plate may move in different directions. The plurality of portions of the filler cap may move in different directions. Further, the directions in which the plurality of portions of the filler volume increasing plate move may be different from the directions in which the plurality of portions of the filler cap move. Referring to FIG. 32, when each of the filler volume increasing plate 570 and the filler cap 580 is divided into four portions, the four portions 581, 582, 583, and 584 of the filler gap may move the east direction, south direction, west direction, an north direction, respectively, while the four portions 571, 572, 573, and 574 of the filler volume increasing plate may move in the northeast, southeast, southwest, and northwest directions, respectively. Referring to FIG. 33, when each of the filler volume increasing plate 570 and the filler cap 580 are divided into six portions, the six portions 581, 582, 583, 584, 585, and 586 of the filler cap may move in directions of 1 o'clock, 3 o'clock, 5 o'clock, 7 o'clock, 9 o'clock, and 11 o'clock, respectively, while the six portions 571, 572, 573, 574, 575, and 576 of the filler volume increasing plate may move in directions of 12 o'clock, 2 o'clock, 4 o'clock, 6 o'clock, 8 o'clock, and 10 o'clock respectively. However, embodiments of the present disclosure are not necessarily limited thereto, and the directions in which the plurality of portions of the filler volume increasing plate move may be the same as the directions in which the plurality of portions of the filler cap move, respectively. FIG. 32 is a schematic diagram illustrating the structure of the shielding plate according to embodiments of the present disclosure. FIG. 33 is a schematic diagram illustrating the structure of the shielding plate according to embodiments of the present disclosure.

The throat structure has been described above with reference to FIGS. 8 to 15, and then a case where the shielding plate 460 is formed as a single layer has been described above with reference to FIGS. 16 to 26. When the shielding plate 460 is formed as a single layer, the shielding plate may be composed of the plate body 530 and the length extension 540. A case where the length extension 540 does not include the inclined surface has been described above with reference to FIGS. 16 to 18. A case where the length extension 540 includes the inclined surface has been described above with reference to FIGS. 19 to 26.

When the shielding plate 460 is formed as a plurality of layers, the plate 460 may be configured to include the filler body 560, the filler volume increasing plate 570, and the filler cap 580. In this case, the filler volume increasing plate 570 and the filler cap 580 may move in the horizontal direction D1 and D2. The filler volume increasing plate 570 and the filler cap 580 may correspond to the length extension 540.

When the moving distance of the filler cap 580 is equal to the moving distance of the filler volume increasing plate 570, the throat structure may be applied to the filler volume increasing plate 570. When the moving distance of the filler cap 580 is larger than the moving distance of the filler volume increasing plate 570, the throat structure may be applied to the filler cap 580.

When the moving distance of the filler cap 580 is equal to the moving distance of the filler volume increasing plate 570, the inclined surface of the length extension 540 may be applied only to the filler volume increasing plate 570. When the moving distance of the filler cap 580 is larger than the moving distance of the filler volume increasing plate 570, the inclined surface of the length extension 540 may be applied to both the filler volume increasing plate 570 and the filler cap 580. Alternatively, the inclined surface of the length extension 540 may be applied only to the filler cap 580.

When the inclined surface of the length extension 540 is applied to both the filler volume increasing plate 570 and the filler cap 580, the throat structure may be applied to the filler body 560. Even when the inclined surface of the length extension 540 is applied only to the filler volume increasing plate 570, the throat structure may be applied to the filler body 560. When the inclined surface of the length extension 540 is applied only to the filler cap 580, the throat structure may be applied to the filler volume increasing plate 570.

The structure of the shielding plate 460 capable of controlling the turbulent flow has been described above. The shielding plate 460 prevents the supercritical fluid from directly affecting the bottom of the substrate W when the supercritical fluid is supplied upwardly at the beginning of the process, and gradually increases the internal pressure and the internal temperature of the chamber housing 410 through circulation of the supercritical fluid, thereby preventing direct and sudden effect on the substrate W as much as possible. However, the turbulent flow occurs due to the specified structure of the shielding plate 460 and the structure of the process chamber, thereby causing pattern collapse near the edge of the substrate W.

The present disclosure provides a structural change having the shielding plate 460 with the throat structure that may minimize the turbulent flow when the supercritical fluid reaches the top of the substrate W. Furthermore, the process performance may be improved by flexibly providing the structural change points to the shielding plate 460 based on the circumstances that may change, such as the process conditions and the structure of the process chamber. According to the present disclosure, the throat structure may be applied to the chamber housing 410.

Next, the structure of the first substrate support 440 capable of controlling the turbulent flow is described. The first substrate support 440 may be made of a polymer that replaces metal. For example, the first substrate support 440 may be made of Polyether Ether Ketone (PEEK). The first substrate support 440 may be formed on the shielding plate 460. The first substrate support 440 may be formed on the filler cap 580. The first substrate support 440 may support the substrate W while being disposed on the filler cap 580. When the filler cap 580 is divided into a plurality of portions, the first substrate support 440 may include the same number of the first substrate supports 440 as the number of the portions of the filler cap 580 to adjust the balance of the substrate W. The first substrate support 440 may include an even number of first substrate supports 440. Preferably, when the number of the portions of the filler cap 580 is n, the number of first substrate supports 440 may be n/m. In this regard, m may be an even natural number. Here, m and n are positive integers.

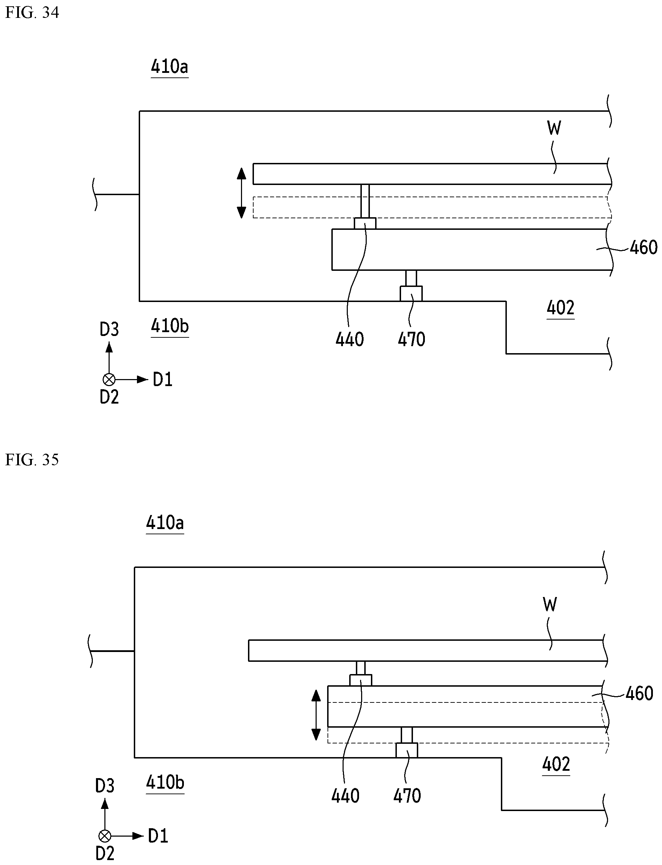

Referring to FIG. 34, the first substrate support 440 may be movable up and down. The first substrate support 440 may be raised and lowered to have a vertical level varying depending on process conditions. Alternatively, the first substrate support 440 may be raised and lowered to have the vertical level varying depending on the process type. The first substrate support 440 may be raised and lowered to have a specified vertical level before starting the drying process. The vertical movement of the first substrate support 440 may control the occurrence of turbulent flow. FIG. 34 is a schematic diagram illustrating the second substrate support according to embodiments of the present disclosure.

Even when the first substrate support 440 rises to its maximum vertical level, a certain distance may be maintained between the inner wall of the upper module 410a and the substrate W. The distance between the inner wall of the upper module 410a and the substrate W may be smaller than P1. For example, P1 may be in a range of 6 mm and 10 mm. For example, P1 may be 6.9 mm.

When the distance between the inner wall of the upper module 410a and the substrate W is P1 or larger, the turbulent flow may occur as the CO₂ supercritical flow hits the wall of the upper module 410a. When the turbulent flow occurs on the wall of the upper module 410a, IPA agglomeration may occur in a pressurization area such that agglomeration of particles, etc. may increase. Furthermore, when the turbulent flow increases to affect the substrate W, the pattern collapse may occur.

The distance between the inner wall of the upper module 410a and the substrate W may be P2 or larger. For example, P2 may be in a range of from 1 mm to 5 mm. P2 may be 4.9 mm. When the distance between the inner wall of the upper module 410a and the substrate W is P2 or larger, the CO₂ supercritical fluid flows toward the top of the substrate W along the inner wall of the lower module 410b and upper module 410a, such that the turbulent flow might not occur.

A height of the first substrate support 440 may be smaller than P3. For example, P3 may be in a range of 11 mm and 15 mm. For example, P3 may be 13.15 mm. When the height of the first substrate support 440 is P3 or higher, the large turbulent flow occurs under the substrate W, and thus the support of the substrate W may become unstable. In this case, vibration of the substrate W may occur during the supercritical drying process, thereby causing the wetted IPA to flow to one side, such that the pattern collapse may occur in an area where an amount of IPA is insufficient.

Next, the structure of the plate support 470 capable of controlling turbulent flow is described. The plate support 470 may be made of metal. For example, the plate support 470 may be made of SUS or STS. The plate support 470 may be formed on the inner surface of the lower module 410b. The plate support 470 may support the shielding plate 460 while being disposed on the inner surface of the lower module 410b. Referring to FIG. 35, the plate support 470 may be raised and lowered. The plate support 470 may be raised and lowered to have a vertical level varying depending on process conditions. Alternatively, the plate support 470 may be raised and lowered to have a vertical level varying depending on the type of process. The plate support 470 may be raised and lowered to have a specified vertical level prior to starting the drying process. The vertical movement of the plate support 470 may control the occurrence of turbulent flow. FIG. 35 is a schematic diagram illustrating the plate support according to embodiments of the present disclosure.

A sum of heights of the first substrate support 440, the shielding plate 460, and the plate support 470 may be smaller than P4. For example, P4 may be in a range of 16 mm and 20 mm. For example, P4 may be 18.15 mm. When the sum is greater than P4, the large turbulent flow occurs under the substrate W, and thus, support of the substrate W may become unstable. In this case, vibration of the substrate W may occur during the supercritical drying process, thereby causing the wetted IPA to flow to one side, such that the pattern collapse may occur in an area where an amount of IPA is insufficient.

The extension and the reduction of the length extension 540 in the shielding plate 460 in the front and back and left and right directions D1 and D2, and the vertical movement of the first substrate support 440 and the plate support 470 in the vertical direction D3, etc. have been described above. The extension and the reduction of the length extension 540 may provide a first change point in the flow path of the supercritical fluid. The first change point may increase the volume of the shielding plate 460. The first change point may adjust the amount of the supercritical fluid used in the process chamber based on the change in the volume of the shielding plate 460. The first change point may adjust the length of the flow path through which the supercritical fluid supplied upwardly passes.

The vertical movement of the first substrate support 440 may provide a second change point in the flow path of the supercritical fluid. The vertical movement of the plate support 470 may provide a third change point in the flow path of the supercritical fluid. The second and third changes may control the distance between the supercritical fluid supplied downwardly and the substrate W. The second and third change points may adjust the spacing between the inner wall of the upper module 410a and the substrate W. The second and third change points may adjust a width of the flow path through which the supercritical fluid supplied upwardly passes by the bottom of the substrate W. The second and third change points may control the magnitude and the direction of the turbulent flow.

The throat structure has been described above with reference to FIG. 8 to FIG. 15, the structure of the shielding plate 460 has been described above with reference to FIG. 16 to FIG. 33, and the structure of the first substrate support 440 has been described above with reference to FIG. 34. The structure of the plate support 470 has been described above with reference to FIG. 35. The throat structure, the shielding plate 460, the first substrate support 440, and the plate support 470 may control the generation of turbulent flow. In this embodiment, the third process chamber 400 may be configured to include the throat structure, the shielding plate 460, the first substrate support 440, and/or the plate support 470 which may be capable of controlling the turbulent flow generation.

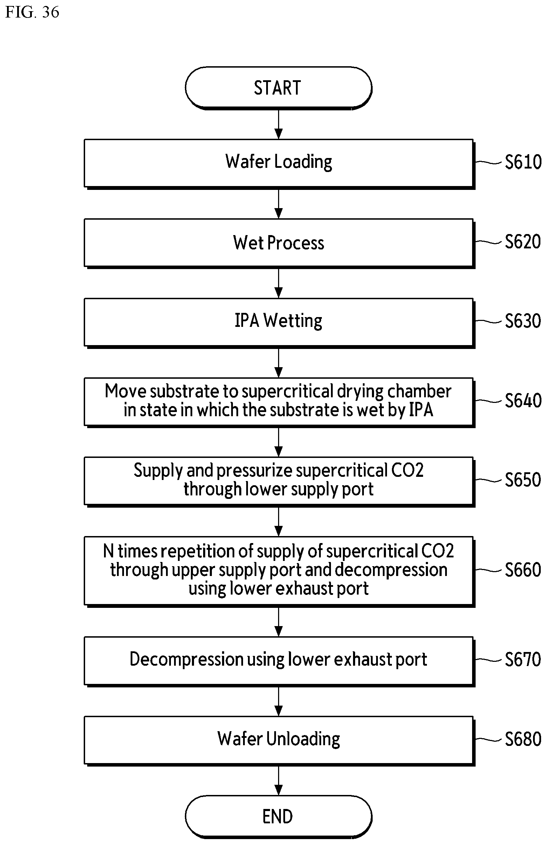

Next, the supercritical drying process of the third process chamber 400 will be described. FIG. 36 is a flowchart illustrating a supercritical drying process according to embodiments of the present disclosure.

When the substrate W includes a pattern that requires the supercritical drying, the substrate W may be loaded into the semiconductor manufacturing equipment 100 in S610 and then may move into the first process chamber 200 as a wet chamber, and then the wet process using the chemical that may comply with the process purpose may be performed in S620. To prevent the pattern collapse and protect the pattern, the IPA is applied on the substrate W at a last step of the wet process in S630. Thereafter, the substrate W moves to the third process chamber 400 in a state in which the IPA is not dried but is applied thereon in S640.

In the third process chamber 400, supercritical CO₂ is initially supplied and pressurized through the second supply port 452 in S650. In this regard, the changes in the flow path width under the filler, the flow path width under the substrate W, the flow path width on top of the substrate W, and the filler volume and width may be made using the improved filler proposed in accordance with the present disclosure, for example, the shielding plate 460. Thus, the flow and velocity of the initially supplied supercritical CO₂ may be controlled such that the turbulent flow affecting the top of the substrate W may be minimized. When teg supercritical CO₂ has been pressurized to a level equal to or higher than a certain level, the supercritical CO₂ is then supplied through the first supply port 451. In this regard, the IPA applied on the substrate W is replaced with supercritical CO₂ through repeated operations in S660 of pressurization using the first supply port 451 and decompression using the exhaust port 453. In this process, the process margin may be secured by adjusting the distance between the first supply port 451 and the substrate W, and the flow shape in the supercritical CO₂ supply and discharge, using the structural change to the improved filler proposed in accordance with the present disclosure. When an entirety of the supercritical CO₂ is discharged through the exhaust port 453 such that the pressure inside the chamber housing 410 is reduced in S670, the substrate W is unloaded in S680 and the supercritical drying process is completed.

Due to the structure of the third process chamber 400, the supercritical fluid supplied upwardly travels along the wall of the chamber and reaches the top of the substrate W. In this regard, the turbulent flow generated by the supercritical fluid that collides with the side surface and the upper wall of the chamber is likely to affect the edge area of the substrate W to apply the shear stress to that area to cause the pattern collapse. In accordance with the present disclosure, the structural changes in the filler structure may be made that may minimize turbulent flow. In the future, the Bar CD of the semiconductor pattern will decrease and the aspect ratio thereof will increase, thereby increasing the difficulty of products. Accordingly, even when the process conditions such as temperature, pressure, and flow rate need to be changed, the optimal chamber structure may be derived by changing the filler structure to suit the process conditions.

Although embodiments of the present disclosure have been described with reference to the accompanying drawings, the present disclosure is not necessarily limited to the above embodiments, but may be implemented in various different forms. A person skilled in the art may appreciate that the present disclosure may be practiced in other concrete forms without changing the technical concept or characteristics of the present disclosure.

## Claims

1. A substrate treating apparatus, comprising:
an upper module including a first supply port providing supercritical fluid to a substrate treating space;
a lower module coupled to the upper module and including a second supply port providing the supercritical fluid to the substrate treating space;
a shielding plate disposed in the substrate treating space;
a plate support coupled to the lower module and supporting the shielding plate; and
a first substrate support coupled to the shielding plate and supporting the substrate,
wherein a fluid flow path between the lower module and the shielding plate includes a throat structure changing a cross-sectional size of the fluid flow path.

2. The substrate treating apparatus of claim 1, wherein the throat structure includes a first protrusion.

3. The substrate treating apparatus of claim 2, wherein the first protrusion is formed on the shielding plate and/or the lower module.

4. The substrate treating apparatus of claim 2, wherein the throat structure further includes a second protrusion.

5. The substrate treating apparatus of claim 1, wherein the shielding plate includes:
a plate body; and
a length extension coupled to an outer side surface of the plate body,
wherein the length extension extends in a length direction thereof in a direction parallel to a width of the plate body.

6. The substrate treating apparatus of claim 5, wherein a thickness of the length extension is smaller than or equal to a thickness of the plate body.

7. The substrate treating apparatus of claim 5, wherein a sum of a width of the plate body and a width of the length extension is smaller than or equal to a width of the substrate.

8. The substrate treating apparatus of claim 5, wherein the length extension includes an inclined surface inclined toward the fluid flow path.

9. The substrate treating apparatus of claim 1, wherein the shielding plate includes:
a filler body;
a filler volume increasing plate stacked on the filler body; and
a filler cap stacked on the filler volume increasing plate,
wherein each of the filler volume increasing plate and the filler cap is movable horizontally.

10. The substrate treating apparatus of claim 9, wherein the filler volume increasing plate and the filler cap are movable independently of each other.

11. The substrate treating apparatus of claim 9, wherein a moving distance of the filler cap is greater than or equal to a moving distance of the filler volume increasing plate.

12. The substrate treating apparatus of claim 9, wherein each of the filler volume increasing plate and the filler cap are divided into a plurality of portions in a plan view.

13. The substrate treating apparatus of claim 12, wherein directions in which the plurality of portions of the filler volume increasing plate move, are different from directions in which the plurality of portions of the filler cap move, respectively.

14. The substrate treating apparatus of claim 1, wherein the first substrate support and/or the plate support is movable vertically.

15. A semiconductor manufacturing equipment, comprising:
a cleaning process chamber configured to wet-clean a substrate using a chemical; and
a drying process chamber configured to dry the substrate having the chemical remaining thereon, using a supercritical fluid,
wherein the drying process chamber includes:
an upper module including a first supply port providing the supercritical fluid to a substrate treating space;
a lower module coupled to the upper module and including a second supply port providing the supercritical fluid to the substrate treating space;
a shielding plate disposed in the substrate treating space;
a plate support coupled to the lower module and supporting the shielding plate; and
a first substrate support coupled to the shielding plate and supporting the substrate,
wherein a fluid flow path between the lower module and the shielding plate includes a throat structure changing a cross-sectional size of the fluid flow path.
